# EUROPEAN PATENT SPECIFICATION

(11) **EP 4 514 110 B1**
(45) Date of publication and mention of the grant of the patent: **25.02.2026**
(21) Application number: 22938482.1
(22) Date of filing: 20.04.2022
(51) Int. Cl.: H10N 60/01, H10N 60/12, H10N 69/00

(54) **METHOD FOR MANUFACTURING JOSEPHSON JUNCTION ELEMENT AND METHOD FOR MANUFACTURING QUANTUM BIT**
VERFAHREN ZUR HERSTELLUNG EINES JOSEPHSON-ÜBERGANGSELEMENTS UND VERFAHREN ZUR HERSTELLUNG EINES QUANTENBITS
PROCÉDÉ DE FABRICATION D'ÉLÉMENT DE JONCTION JOSEPHSON ET PROCÉDÉ DE FABRICATION DE BIT QUANTIQUE

(43) Date of publication of application: 26.02.2025
(73) Proprietor: FUJITSU LIMITED, Kawasaki-shi, Kanagawa 211-8588 (JP)
(72) Inventor: TAKAHASHI, Tsuyoshi, Kawasaki-shi, Kanagawa 211-8588 (JP)
(74) Representative: Haseltine Lake Kempner LLP
(86) International application number: PCT/JP2022/018279
(87) International publication number: WO 2023/203679

(56) References cited:
- JP-A- 2020 535 461
- JP-A- 2021 503 171
- US-A1- 2019 137 891
- US-A1- 2021 135 085
- US-A1- 2021 135 085
- US-A1- 2021 208 509
- US-A1- 2021 313 507
- US-A1- 2021 399 199
- KREIKEBAUM J M ET AL: "Improving wafer-scale Josephson junction resistance variation in superconducting quantum coherent circuits", SUPERCONDUCTOR SCIENCE AND TECHNOLOGY, IOP PUBLISHING, TECHNO HOUSE, BRISTOL, GB, vol. 33, no. 6, 29 April 2020 (2020-04-29), XP020353738, ISSN: 0953-2048, [retrieved on 20200429], DOI: 10.1088/1361-6668/AB8617

## Description

The present invention relates to a method for manufacturing a Josephson junction device and a method for manufacturing a qubit.

### BACKGROUND

A qubit including a transmon in which a Josephson junction device and a capacitor are coupled in parallel is known. The Josephson junction device has a structure in which an insulating film is sandwiched between two layers of superconducting films. It is known that the superconducting film is formed by film formation from an oblique direction (for example, Patent Documents 1 and 2).

In a case where the superconducting film is formed by the film formation from the oblique direction (for example, oblique deposition), a difference in a width dimension of the superconducting film may occur in a substrate due to a difference in an incident angle of a film formation material to an opening of a mask layer. Thus, it is known that the width dimension of the superconducting film in the substrate is made substantially the same even in a case where the incident angle of the film formation material to the opening of the mask layer is different by correcting a width dimension of the opening of the mask layer (for example, Patent Document 3). Furthermore, it is known that the width dimension of the superconducting film in the substrate is made substantially the same by using a mask close to a wafer and moving the substrate while making an incident angle of the film formation material to an opening of the mask constant (for example, Patent Document 4).
Reference may be made to any of:
US 202 1/0208509 A1, which relates to a method of fabricating a circuit element, such as a quantum computing circuit element, including obtaining a lithography mask write file that includes mask information characterizing one or more mask features, obtaining a uniformity function that is configured to modify the mask information to compensate for a non-uniform deposition process, applying the uniformity function to the lithography mask write to obtain a modified lithography mask write file, and performing lithography as directed by the modified lithography mask write file; and
a paper by Kreikebaum J M et al titled "Improving wafer-scale Josephson junction resistance variation in superconducting quantum coherent circuits", in Superconductor Science and Technology, vol. 33, no 6, 29 April 2020, DOI: 10.1088/1361-6668/AB8617.

### SUMMARY

### TECHNICAL PROBLEM

In the method of correcting the width dimension of the opening of the mask layer as described in Patent Document 3, there is room left for improvement in terms of suppressing variation in the width dimension of the superconducting film in the substrate. In the method of moving the substrate while making the incident angle of the film formation material constant using the mask as described in Patent Document 4, a special device is needed.

In one aspect, an object is to suppress variation in a width dimension of a superconducting film in a substrate and to suppress variation in an area of a Josephson junction.

### SOLUTION TO PROBLEM

In one aspect, a method for manufacturing a Josephson junction device includes: forming a mask layer on a substrate; forming, with the mask layer as a mask, a first superconducting film above the substrate by first film formation from a first oblique direction relative to the substrate; forming an insulating film at a surface of the first superconducting film; and forming, with the mask layer as the mask, a second superconducting film that has a region that overlaps the first superconducting film via the insulating film by second film formation from a second oblique direction different from the first oblique direction relative to the substrate, in which, in the forming the mask layer, the mask layer is formed that includes: a first mask pattern that is positioned in a first region of the substrate and includes a first opening that extends along an incident direction of a film formation material in one film formation of the first film formation and the second film formation and a second opening that extends in a direction that intersects the first opening; and a second mask pattern that is positioned in a second region of the substrate and includes a third opening that extends inclined relative to the first opening along the incident direction of the film formation material in the one film formation and a fourth opening that extends in a direction that intersects the third opening, and the second region is positioned closer to an end of the substrate than the first region.

In one aspect, a method for manufacturing a qubit includes: forming a Josephson junction device; and forming a capacitor coupled in parallel to the Josephson junction device, in which the forming the Josephson junction device includes: forming a mask layer on a substrate; forming, with the mask layer as a mask, a first superconducting film above the substrate by first film formation from a first oblique direction relative to the substrate; forming an insulating film at a surface of the first superconducting film; and forming, with the mask layer as the mask, a second superconducting film that has a region that overlaps the first superconducting film via the insulating film by second film formation from a second oblique direction different from the first oblique direction relative to the substrate, and in the forming the mask layer, the mask layer is formed that includes: a first mask pattern that is positioned in a first region of the substrate and includes a first opening that extends along an incident direction of a film formation material in one film formation of the first film formation and the second film formation and a second opening that extends in a direction that intersects the first opening; and a second mask pattern that is positioned in a second region of the substrate and includes a third opening that extends inclined relative to the first opening along the incident direction of the film formation material in the one film formation and a fourth opening that extends in a direction that intersects the third opening, and the second region is positioned closer to an end of the substrate than the first region.

### ADVANTAGEOUS EFFECTS OF INVENTION

As one aspect, variation in a width dimension of a superconducting film in a substrate may be suppressed, and variation in an area of a Josephson junction may be suppressed.

### BRIEF DESCRIPTION OF DRAWINGS

FIGs. 1A to 1C are views (part 1) illustrating a method for manufacturing a Dolan Bridge Josephson junction device.
FIGs. 2A and 2B are views (part 2) illustrating the method for manufacturing the Dolan Bridge Josephson junction device.
FIGs. 3A and 3B are diagrams illustrating film formation of a superconducting film at a wafer-like substrate by an oblique vacuum deposition method in the Dolan Bridge Josephson junction device.
FIGs. 4A to 4C are views illustrating an incident angle of a deposition material to a mask pattern of regions A to C in FIGs. 3A and 3B.
FIGs. 5A to 5C are views illustrating Josephson junction devices formed in the regions A to C in FIGs. 3A and 3B.
FIGs. 6A to 6C are plan views (part 1) illustrating a method for manufacturing the Josephson junction device according to a first embodiment.
FIGs. 7A to 7C are plan views (part 2) illustrating the method for manufacturing the Josephson junction device according to the first embodiment.
FIGs. 8A to 8C are plan views (part 3) illustrating the method for manufacturing the Josephson junction device according to the first embodiment.
FIGs. 9A to 9C are plan views (part 4) illustrating the method for manufacturing the Josephson junction device according to the first embodiment.
FIGs. 10A to 10C are plan views (part 5) illustrating the method for manufacturing the Josephson junction device according to the first embodiment.
FIGs. 11A to 11C are views (part 1) illustrating a method for manufacturing a Manhattan Josephson junction device.
FIGs. 12A and 12B are views (part 2) illustrating the method for manufacturing the Manhattan Josephson junction device.
FIGs. 13A and 13B are diagrams illustrating film formation of a superconducting film at a wafer-like substrate by the oblique vacuum deposition method in the Manhattan Josephson junction device.
FIGs. 14A to 14I are views illustrating an incident angle of a deposition material to a mask pattern of regions A to I in FIGs. 13A and 13B.
FIGs. 15A to 15I are views illustrating Josephson junction devices formed in the regions A to I in FIGs. 13A and 13B.
FIGs. 16A to 16I are plan views (part 1) illustrating a method for manufacturing the Josephson junction device according to a second embodiment.
FIGs. 17A to 17I are plan views (part 2) illustrating the method for manufacturing the Josephson junction device according to the second embodiment.
FIGs. 18A to 18I are plan views (part 3) illustrating the method for manufacturing the Josephson junction device according to the second embodiment.
FIGs. 19A to 19I are plan views (part 4) illustrating the method for manufacturing the Josephson junction device according to the second embodiment.
FIGs. 20A to 20I are plan views (part 5) illustrating the method for manufacturing the Josephson junction device according to the second embodiment.
FIG. 21 is a plan view of a model used to examine a correlation between an intersection angle of superconducting films and an area of Josephson junctions.
FIG. 22 is a circuit diagram of a qubit according to a third embodiment.
FIGs. 23A and 23B are plan views illustrating the qubit according to the third embodiment.

### DESCRIPTION OF EMBODIMENTS

Hereinafter, embodiments of the present invention will be described with reference to the drawings.

### [First Embodiment]

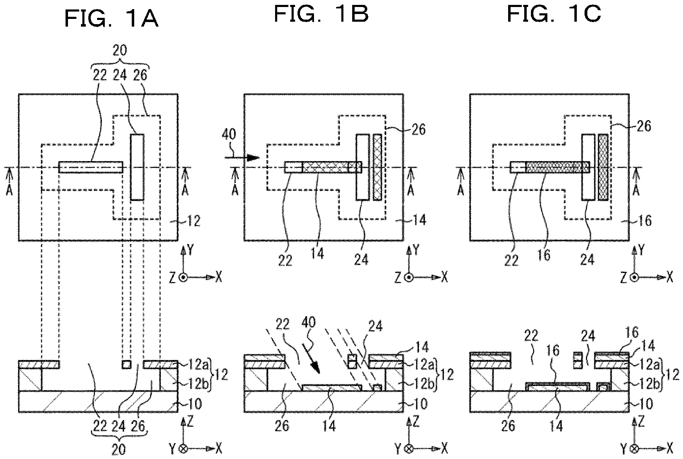

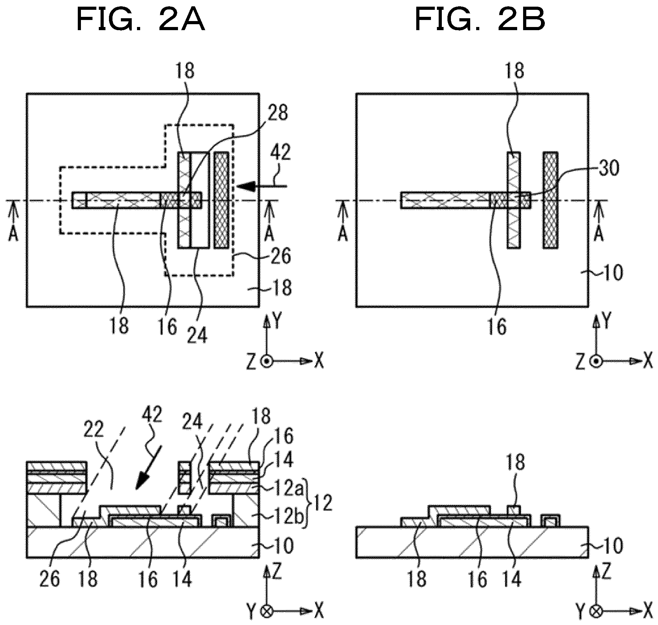

In a first embodiment, a Dolan Bridge Josephson junction device will be described. FIGs. 1A to 2B are views illustrating a method for manufacturing the Dolan Bridge Josephson junction device. Upper views of FIGs. 1A to 2B are plan views illustrating the method for manufacturing the Dolan Bridge Josephson junction device, and lower views are cross-sectional views taken along a line A-A of the upper views. A normal direction of an upper surface of a substrate 10 is defined as a Z-axis direction, and directions orthogonal to each other in a surface direction of the upper surface of the substrate 10 are defined as an X-axis direction and a Y-axis direction. In the upper plan views of FIGs. 1B to 2B, a superconducting film 14, an insulating film 16, and a superconducting film 18 formed in a gap 26 are hatched for clarity of the drawings.

As in FIG. 1A, a mask layer 12 is formed on the substrate 10. The mask layer 12 has an upper layer 12a and a lower layer 12b. A mask pattern 20 including an opening 22, an opening 24, and the gap 26 is formed in the mask layer 12. The opening 22 extends in the X-axis direction, the opening 24 extends in the Y-axis direction, and both are formed in the upper layer 12a. The opening 22 and the opening 24 are formed at an appropriate distance apart. The gap 26 is formed in the lower layer 12b. The gap 26 is positioned below the openings 22 and 24, and has a larger shape than the openings 22 and 24 in plan view. The mask layer 12 is formed of, for example, a resist. For the lower layer 12b, a resist having higher sensitivity to exposure (for example, electron beam (EB) exposure) and development for forming the openings 22 and 24 and the gap 26 than that of the upper layer 12a is used. Therefore, when the openings 22 and 24 are formed in the upper layer 12a, the gap 26 larger than the openings 22 and 24 is formed in the lower layer 12b. A portion of the upper layer 12a positioned between the opening 22 and the opening 24 is formed so as to float over the gap 26.

As in FIG. 1B, the superconducting film 14 is formed above the substrate 10 from obliquely above in a -X direction as indicated by an arrow 40, using the mask layer 12 as a mask. For example, the superconducting film 14 is formed by an oblique vacuum deposition method. Since the superconducting film 14 is formed above the substrate 10 from obliquely above in the -X direction, the superconducting film 14 formed in the gap 26 is formed to be shifted in a +X direction relative to the openings 22 and 24. The superconducting film 14 has, for example, a width of about 100 nm to 300 nm, and a thickness of about 10 nm to 100 nm.

As in FIG. 1C, while maintaining a vacuum state when the superconducting film 14 is formed, oxygen is introduced into a chamber to oxidize a surface of the superconducting film 14, and the insulating film 16 is formed at the surface of the superconducting film 14. The insulating film 16 has a thickness of, for example, about 1 nm to 5 nm.

As in FIG. 2A, the superconducting film 18 is formed above the substrate 10 from obliquely above in the +X direction as indicated by an arrow 42, using the mask layer 12 as the mask. For example, the superconducting film 18 is formed by the oblique vacuum deposition method. Since the superconducting film 18 is formed above the substrate 10 from obliquely above in the +X direction, the superconducting film 18 formed in the gap 26 is formed to be shifted in the -X direction relative to the openings 22 and 24. Therefore, a region 28 in which the superconducting film 14 extending in the X-axis direction and the superconducting film 18 extending in the Y-axis direction overlap each other via the insulating film 16 is formed. The superconducting film 18 has, for example, a width of about 100 nm to 300 nm, and a thickness of about 10 nm to 100 nm.

As in FIG. 2B, the mask layer 12, and the superconducting film 14, the insulating film 16, and the superconducting film 18 formed above the mask layer 12 are removed by a lift-off method. The region 28 in which the superconducting film 14 extending in the X-axis direction and the superconducting film 18 extending in the Y-axis direction overlap each other via the insulating film 16 becomes a Josephson junction 30.

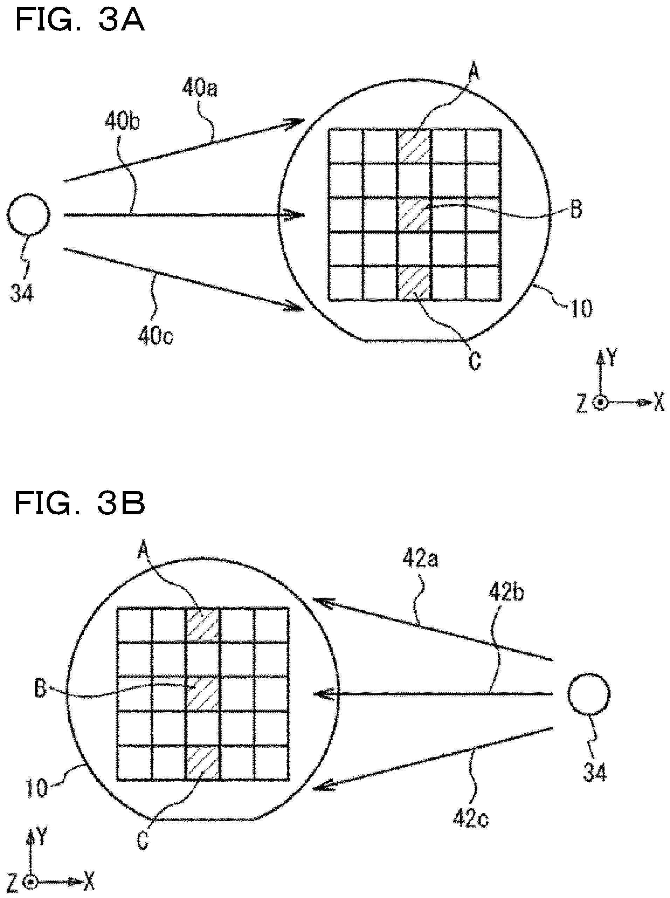

A problem occurring in the Dolan Bridge Josephson junction device will be described with reference to FIGs. 3A to 5C. In FIGs. 3A and 3B, film formation of the superconducting films 14 and 18 above the wafer-like substrate 10 by the oblique vacuum deposition method in the Dolan Bridge Josephson junction device is illustrated. As in FIG. 3A, by vaporizing or sublimating a deposition material of a deposition source 34 positioned in the -X direction relative to the substrate 10, the deposition material is made incident to the substrate 10 from obliquely above in the -X direction to form the superconducting film 14. At this time, the deposition source 34 is not positioned at infinity relative to the substrate 10, but is placed at a realistic distance of, for example, about 50 cm from the substrate 10. Thus, as indicated by arrows 40a, 40b, and 40c, an incident angle of the deposition material of the deposition source 34 is different in the Y-axis direction of the substrate 10. In other words, the incident angle of the deposition material of the deposition source 34 is different in a region A positioned on a side of a +Y direction, a region B positioned at a center in the Y-axis direction, and a region C positioned on a side of a -Y direction in the substrate 10. Similarly, as in FIG. 3B, by vaporizing or sublimating the deposition material of the deposition source 34 positioned in the +X direction relative to the substrate 10, the deposition material is made incident to the substrate 10 from obliquely above in the +X direction to form the superconducting film 18. Thus, as indicated by arrows 42a, 42b, and 42c, the incident angle of the deposition material of the deposition source 34 is different in the Y-axis direction of the substrate 10. In other words, the incident angle of the deposition material of the deposition source 34 is different in the region A positioned on the side of the +Y direction, the region B positioned at the center in the Y-axis direction, and the region C positioned on the side of the -Y direction in the substrate 10. The larger the substrate 10, the larger a difference in the incident angle of the deposition material between the region B and the regions A and C.

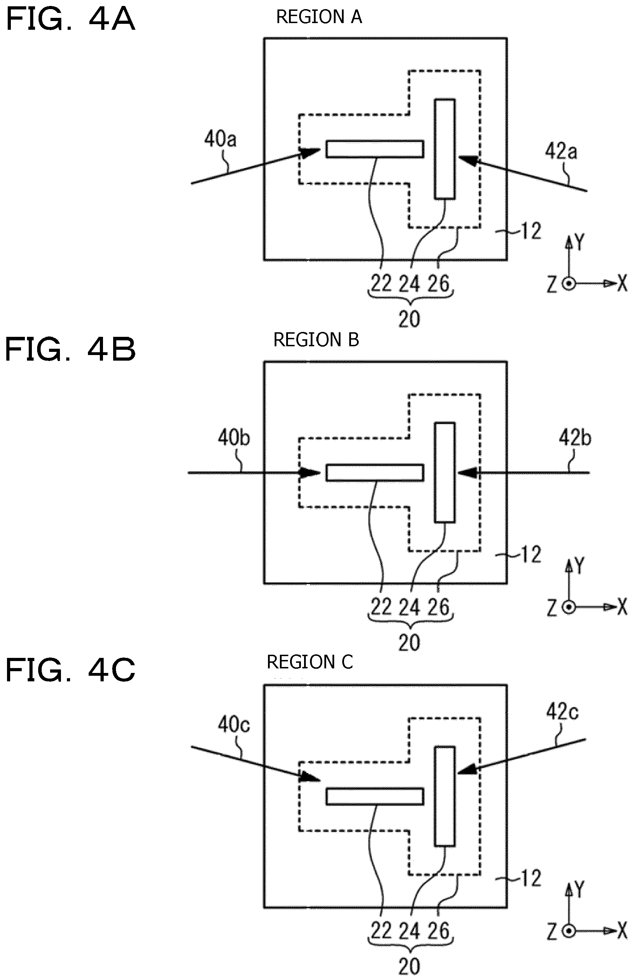

In FIGs. 4A to 4C, the incident angle of the deposition material to the mask pattern 20 of the regions A, B, and C in FIGs. 3A and 3B is illustrated. As in FIGs. 4A to 4C, it is assumed that the opening 22 included in the mask pattern 20 extends in the X-axis direction and the opening 24 extends in the Y-axis direction in all of the regions A, B, and C. In this case, as in FIG. 4B, with respect to the region B positioned at the center in the Y-axis direction, the deposition material is incident to the openings 22 and 24 from a direction substantially parallel to the X-axis direction as indicated by the arrows 40b and 42b. On the other hand, as in FIG. 4A, with respect to the region A positioned on the side of the +Y direction, the deposition material is incident to the openings 22 and 24 from a direction inclined in the -Y direction relative to the X-axis direction as indicated by the arrows 40a and 42a. As in FIG. 4C, with respect to the region C positioned on the side of the -Y direction, the deposition material is incident to the openings 22 and 24 from a direction inclined in the +Y direction relative to the X-axis direction as indicated by the arrows 40c and 42c.

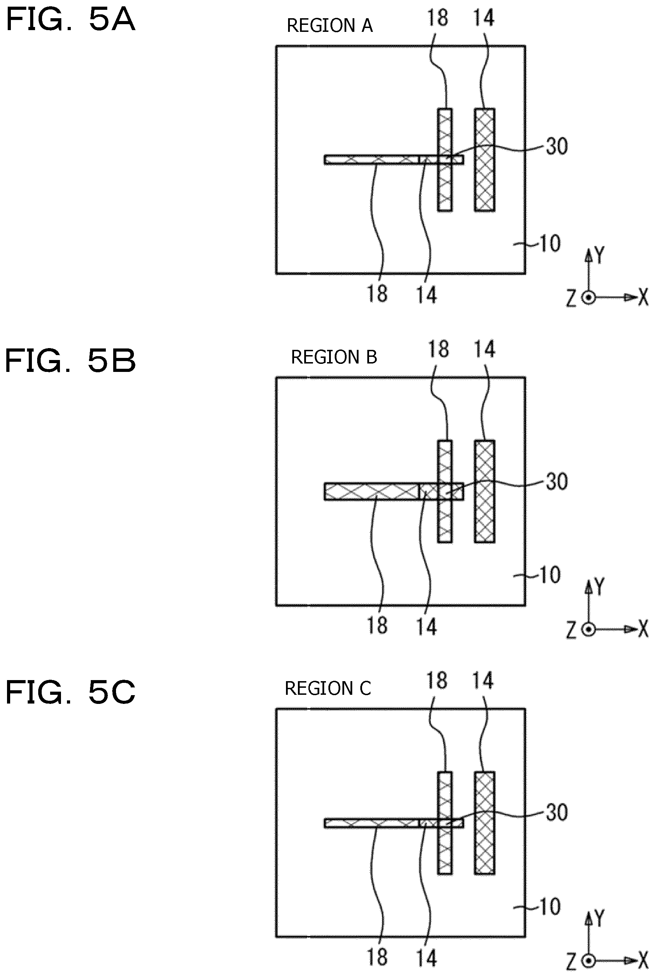

In FIGs. 5A to 5C, Josephson junction devices formed in the regions A, B, and C in FIGs. 3A and 3B are illustrated. Note that, in FIGs. 5A to 5C, the superconducting film 14 is illustrated through the insulating film 16. As illustrated in FIG. 4B, in the region B, the deposition material is incident to the opening 22 extending in the X-axis direction from the direction substantially parallel to the X-axis direction. Thus, as in FIG. 5B, the superconducting films 14 and 18 formed to extend in the X-axis direction are formed to have substantially the same width as a width of the opening 22. On the other hand, as illustrated in FIGs. 4A and 4C, in the regions A and C, the deposition material is incident to the opening 22 extending in the X-axis direction from the direction inclined in the -Y direction or the +Y direction relative to the X-axis direction. Thus, as in FIGs. 5A and 5C, the superconducting films 14 and 18 formed to extend in the X-axis direction are formed to be narrower than the width of the opening 22.

Characteristics of the Josephson junction device are affected by an area of the Josephson junction 30 in which the superconducting film 14 and the superconducting film 18 overlap each other via the insulating film 16. For example, in a qubit using a transmon in which a Josephson junction device and a capacitor are coupled in parallel, when variation occurs in the area of the Josephson junction 30, the variation is reflected in variation of the qubit and becomes a factor of lowering fidelity. Therefore, as in FIGs. 5A to 5C, when the area of the Josephson junction 30 varies in the Y-axis direction in the substrate 10, the characteristics of the Josephson junction device vary, and as a result, the fidelity of the qubit is lowered. In the future, as integration of qubits progresses, and an area of a qubit chip increases, several (for example, one to five, or the like) qubit chips are formed at the wafer-like substrate 10. In this case, the characteristics of the Josephson junction devices vary in the qubit chip, and the fidelity of the qubit is lowered.

Thus, a manufacturing method for suppressing variation in the area of the Josephson junction 30 in the substrate 10 small in the Dolan Bridge Josephson junction device will be described below.

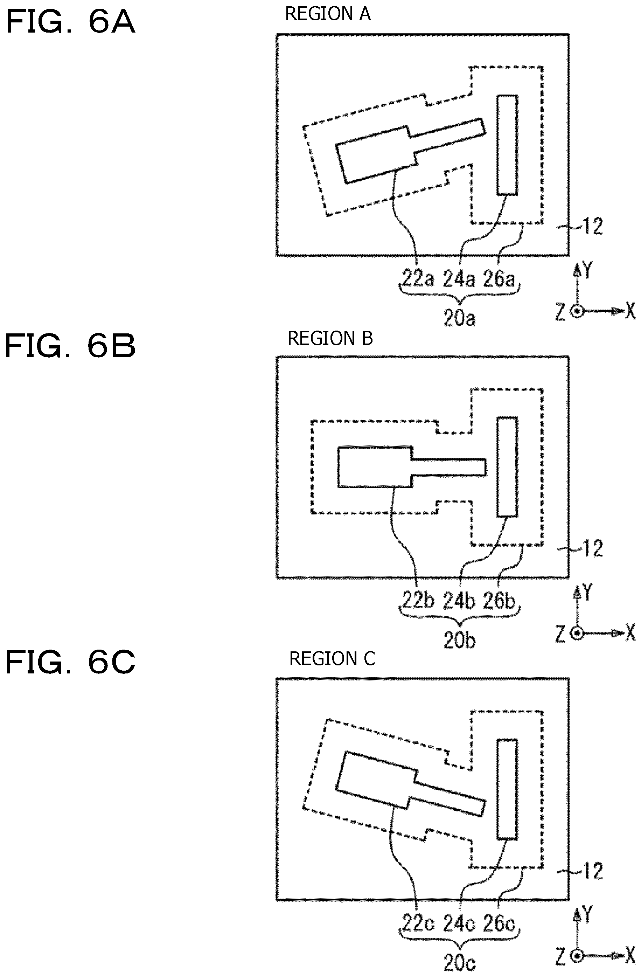

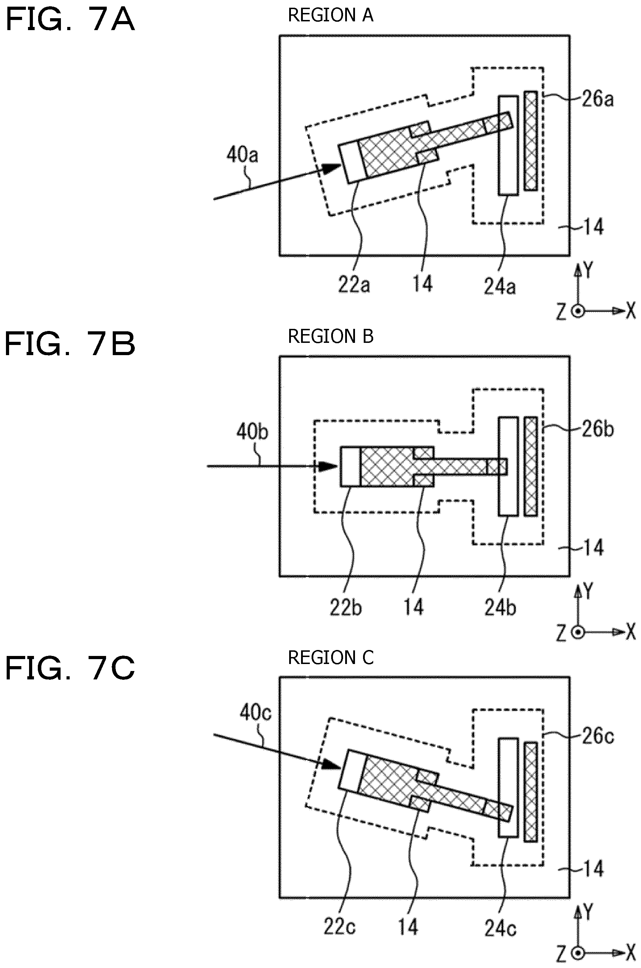

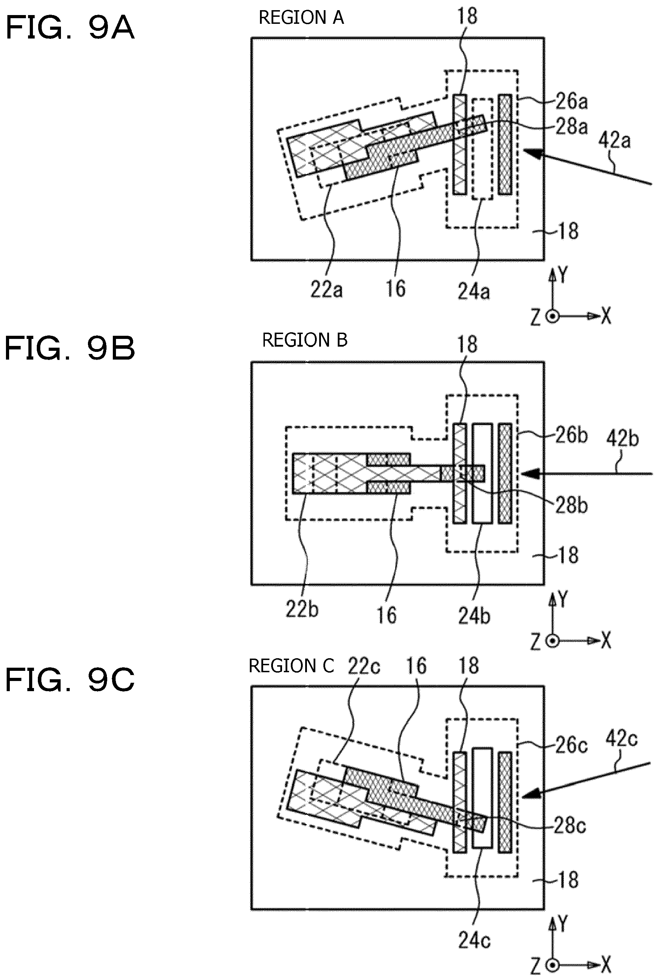

FIGs. 6A to 10C are plan views illustrating a method for manufacturing the Josephson junction device according to the first embodiment. FIGs. 6A, 7A, 8A, 9A, and 10A are plan views of portions corresponding to the region A in FIGs. 3A and 3B. FIGs. 6B, 7B, 8B, 9B, and 10B are plan views of portions corresponding to the region B in FIGs. 3A and 3B. FIGs. 6C, 7C, 8C, 9C, and 10C are plan views of portions corresponding to the region C in FIGs. 3A and 3B. In FIGs. 7A to 10C, the superconducting film 14, the insulating film 16, and the superconducting film 18 formed in gaps 26a to 26c are illustrated by hatching for clarity of the drawings. Furthermore, in FIGs. 9A to 9C, openings 22a to 22c and openings 24a to 24c are illustrated by dotted lines for clarity of the drawings.

As in FIGs. 6A to 6C, the mask layer 12 having the upper layer 12a and the lower layer 12b is formed on the wafer-like substrate 10 (see also FIGs. 1A, 3A and 3B). The substrate 10 is, for example, a high-resistance silicon substrate, and the mask layer 12 is formed of, for example, a resist. In the mask layer 12, mask patterns 20a, 20b, and 20c are formed in the regions A, B, and C. As in FIG. 6A, the mask pattern 20a formed in the region A includes the opening 22a that is horizontally long and extends inclined in the +Y direction from the -X direction toward the +X direction, the opening 24a that is vertically long and extends in the Y-axis direction, and the gap 26a. The opening 24a is provided apart from the opening 22a by an appropriate distance in the +X direction. The openings 22a and 24a are formed in the upper layer 12a. The gap 26a has a shape larger than the openings 22a and 24a in plan view, is positioned below the openings 22a and 24a, and is formed in the lower layer 12b.

As in FIG. 6B, the mask pattern 20b formed in the region B includes the opening 22b that is horizontally long and extends in the X-axis direction, the opening 24b that is vertically long and extends in the Y-axis direction, and the gap 26b. The opening 24b is provided apart from the opening 22b by an appropriate distance in the +X direction. The openings 22b and 24b are formed in the upper layer 12a. The gap 26b has a shape larger than the openings 22b and 24b in plan view, is positioned below the openings 22b and 24b, and is formed in the lower layer 12b. As in FIG. 6C, the mask pattern 20c formed in the region C includes the opening 22c that is horizontally long and extends inclined in the -Y direction from the -X direction toward the +X direction, the opening 24c that is vertically long and extends in the Y-axis direction, and the gap 26c. The opening 24c is provided apart from the opening 22c by an appropriate distance in the +X direction. The openings 22c and 24c are formed in the upper layer 12a. The gap 26c has a shape larger than the openings 22c and 24c, is positioned below the openings 22c and 24c, and is formed in the lower layer 12b.

In the openings 22a, 22b, and 22c, a width of a portion positioned on a side of the -X direction is larger than a width of a portion positioned on a side of the +X direction. For example, in the openings 22a, 22b, and 22c, a length of the portion having the large width is 80% or more and 120% or less of a length of the portion having the small width, or may be 85% or more and 115% or less, or 90% or more and 110% or less.

The openings 22a, 22b, and 22c mutually have the same width dimension in both the portion having the large width and the portion having the small width. Furthermore, the openings 22a, 22b, and 22c mutually have the same length dimension. Similarly, the openings 24a, 24b, and 24c mutually have the same width dimension and length dimension.

As in FIGs. 7A to 7C, the superconducting film 14 is formed above the substrate 10 from obliquely above in the -X direction using the mask layer 12 as a mask by using the oblique vacuum deposition method. For example, an aluminum (Al) film is formed as the superconducting film 14. In the region A, the deposition material is incident to the openings 22a and 24a from the direction inclined in the -Y direction relative to the X-axis direction as indicated by the arrow 40a. The opening 22a is inclined in the +Y direction from the -X direction toward the +X direction, and is formed along the incident direction of the deposition material. Thus, the superconducting film 14 having substantially the same width as that of the opening 22a is formed in the gap 26a. The superconducting film 14 formed in the gap 26a by the openings 22a and 24a is formed to be shifted toward the side of the +X direction relative to the openings 22a and 24a.

In the region B, the deposition material is incident to the openings 22b and 24b, substantially parallel to the X-axis direction as indicated by the arrow 40b. The opening 22b extends in the X-axis direction, and is formed along the incident direction of the deposition material. Thus, also in the region B, the superconducting film 14 having substantially the same width as a width of the opening 22b is formed in the gap 26b. The superconducting film 14 formed in the gap 26b by the openings 22b and 24b is formed to be shifted toward the side of the +X direction relative to the openings 22b and 24b.

In the region C, the deposition material is incident to the openings 22c and 24c from the direction inclined in the +Y direction relative to the X-axis direction as indicated by the arrow 40c. The opening 22c is inclined in the -Y direction from the -X direction toward the +X direction, and is formed along the incident direction of the deposition material. Thus, also in the region C, the superconducting film 14 having substantially the same width as a width of the opening 22c is formed in the gap 26c. The superconducting film 14 formed in the gap 26c by the openings 22c and 24c is formed to be shifted toward the side of the +X direction relative to the openings 22c and 24c.

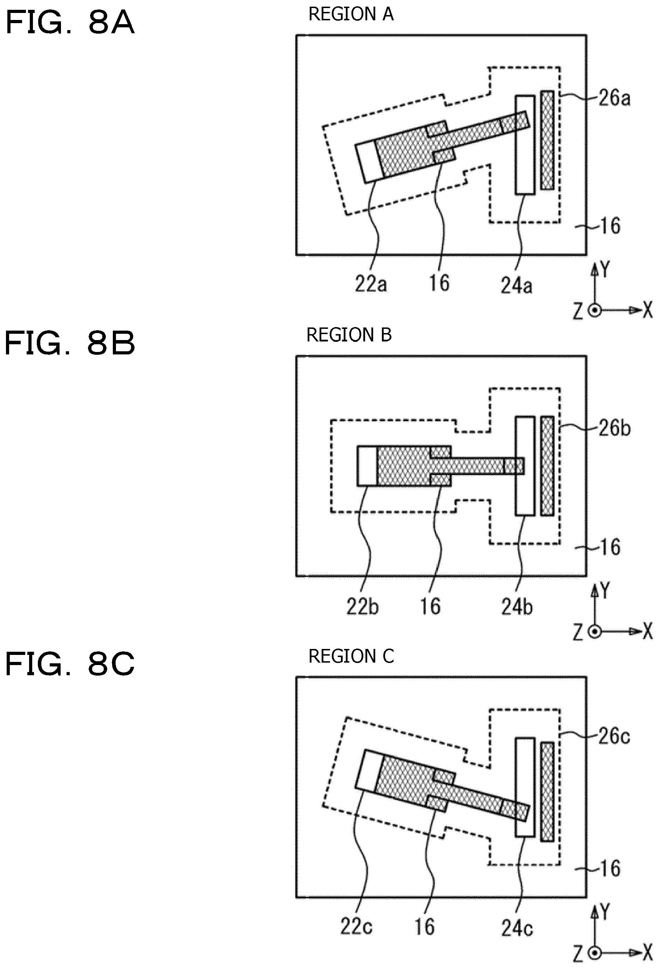

As in FIGs. 8A to 8C, while maintaining the vacuum state when the superconducting film 14 is formed, oxygen is introduced into the chamber to oxidize the surface of the superconducting film 14. and the insulating film 16 is formed at the surface of the superconducting film 14.

As in FIGs. 9A to 9C, the superconducting film 18 is formed above the substrate 10 from obliquely above in the +X direction using the mask layer 12 as the mask by using the oblique vacuum deposition method. For example, an aluminum (Al) film is formed as the superconducting film 18. In the region A, the deposition material is incident to the openings 22a and 24a from the direction inclined in the -Y direction relative to the X-axis direction as indicated by the arrow 42a. Since the opening 22a is inclined in the +Y direction from the -X direction toward the +X direction, the superconducting film 18 formed in the gap 26a by the opening 22a is formed to be obliquely shifted to the side of the -X direction relative to the superconducting film 14. At this time, since the opening 22a is thick on the side of the -X direction, a part of the superconducting film 18 is formed to overlap a part of the superconducting film 14. The superconducting film 18 formed in the gap 26a by the opening 24a is also formed to be shifted toward the side of the -X direction relative to the opening 24a.

In the region B, the deposition material is incident to the openings 22b and 24b, substantially parallel to the X-axis direction as indicated by the arrow 42b. Since the opening 22b extends in the X-axis direction, the superconducting film 18 formed in the gap 26b by the opening 22b is formed to be shifted in the -X direction relative to the superconducting film 14. A part of the superconducting film 18 is formed to overlap a part of the superconducting film 14. The superconducting film 18 formed in the gap 26b by the opening 24b is also formed to be shifted in the -X direction relative to the opening 24b.

In the region C, the deposition material is incident to the openings 22c and 24c from the direction inclined in the +Y direction relative to the X-axis direction as indicated by the arrow 42c. Since the opening 22c is inclined in the -Y direction from the -X direction toward the +X direction, the superconducting film 18 formed in the gap 26c by the opening 22c is formed to be obliquely shifted to the side of the -X direction relative to the superconducting film 14. At this time, since the opening 22c is thick on the side of the -X direction, a part of the superconducting film 18 is formed to overlap a part of the superconducting film 14. The superconducting film 18 formed in the gap 26c by the opening 24c is also formed to be shifted toward the side of the -X direction relative to the opening 24c.

In the respective regions A, B, and C, regions 28a, 28b, and 28c in which the superconducting film 14 extending in the X-axis direction and the superconducting film 18 extending in the Y-axis direction overlap each other via the insulating film 16 are formed.

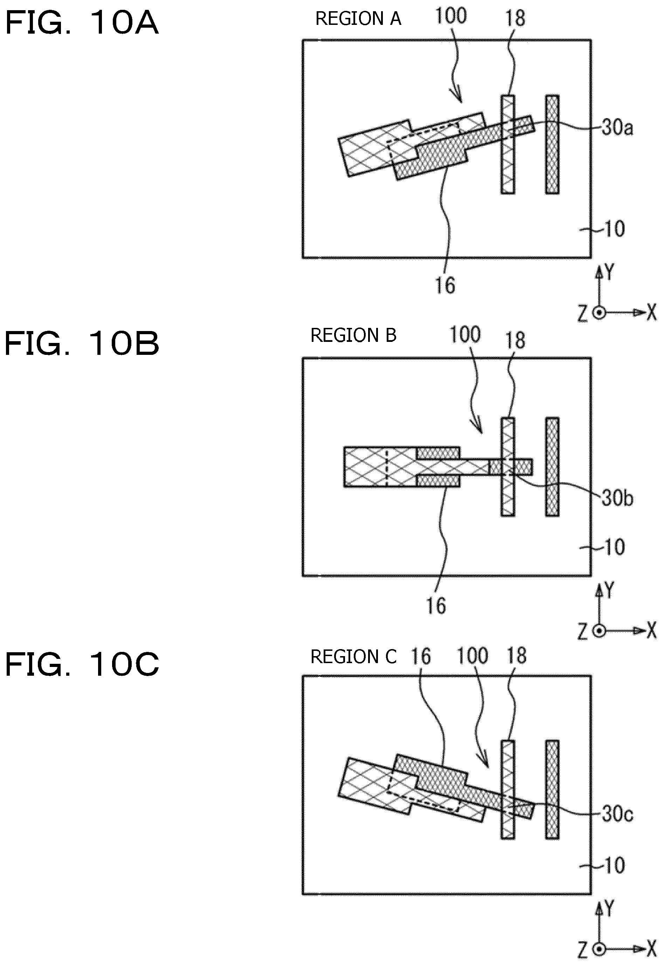

As in FIGs. 10A to 10C, the mask layer 12, and the superconducting film 14, the insulating film 16, and the superconducting film 18 formed above the mask layer 12 are removed by the lift-off method. The regions 28a, 28b, and 28c in which the superconducting film 14 extending in the X-axis direction and the superconducting film 18 extending in the Y-axis direction overlap each other via the insulating film 16 become Josephson junctions 30a, 30b, and 30c. Therefore, a Dolan Bridge Josephson junction device 100 is formed in each of the regions A, B, and C.

As described above, according to the first embodiment, the mask pattern 20b (first mask pattern) positioned in the region B (first region) of the substrate 10 includes the opening 22b (first opening) and the opening 24b (second opening) as in FIG. 6B. As in FIG. 7B, the opening 22b extends along the incident direction of the film formation material when the superconducting film 14 is formed from obliquely above in the -X direction (first oblique direction). The opening 24b extends in a direction intersecting the opening 22b. The mask pattern 20a (second mask pattern) positioned in the region A (second region) positioned closer to an end of the substrate 10 than the region B includes the opening 22a (third opening) and the opening 24a (fourth opening) as in FIG. 6A. As in FIG. 7A, the opening 22a extends inclined relative to the opening 22b (first opening) along the incident direction of the film formation material when the superconducting film 14 is formed from obliquely above in the -X direction (first oblique direction). The opening 24a extends in a direction intersecting the opening 22a. Therefore, the width dimension of the superconducting film 14 formed by the openings 22a and 22b becomes substantially the same as the width dimension of the openings 22a and 22b, and variation in the width dimension of the superconducting film 14 formed in the regions A and B may be suppressed. Therefore, variation in areas of the Josephson junctions 30a and 30b may be suppressed. Since the width dimension of the superconducting film 14 formed by the openings 22a and 22b is substantially determined by the width dimensions of the openings 22a and 22b, and the width dimensions of the openings 22a and 22b may be accurately controlled, the width dimension of the superconducting film 14 may be accurately controlled.

Furthermore, according to the first embodiment, the width dimension of the opening 22b of the mask pattern 20b formed in the region B is the same as the width dimension of the opening 22a of the mask pattern 20a formed in the region A. Therefore, the width dimension of the superconducting film 14 formed by the opening 22a and the width dimension of the superconducting film 14 formed by the opening 22b become substantially the same. Therefore, variation in areas of the Josephson junctions 30a and 30b may be suppressed. The fact that the width dimensions are the same also includes a case where the width dimensions are different to an extent of a manufacturing error.

Furthermore, according to the first embodiment, the openings 22a and 24a of the mask pattern 20a are formed in the upper layer 12a of the mask layer 12, and the gap 26a is formed below the openings 22a and 24a in the lower layer 12b in the shape larger than the openings 22a and 24a in plan view. Similarly, the openings 22b and 24b of the mask pattern 20b are formed in the upper layer 12a of the mask layer 12, and the gap 26b is formed below the openings 22b and 24b in the lower layer 12b in the shape larger than the openings 22b and 24b in plan view. By using such mask patterns 20a and 20b, the Josephson junction devices 100 as in FIGs. 10A and 10B are formed.

Furthermore, according to the first embodiment, the film formation of the superconducting film 14 is performed from obliquely above in the -X direction (first oblique direction), and the film formation of the superconducting film 18 is performed from obliquely above in the +X direction (second oblique direction) on a side opposite to the film formation of the superconducting film 14 (for example, different by 180°) relative to the substrate 10. As in FIGs. 6A and 6B, the mask patterns 20a and 20b are provided side by side in the Y-axis direction (first direction) intersecting (for example, orthogonal to) the -X direction and the +X direction. The opening 24b of the mask pattern 20b is provided apart from the opening 22b in the X-axis direction (second direction orthogonal to the first direction). The opening 24a of the mask pattern 20a is provided apart from the opening 22a in the X-axis direction, and extends in the same direction as the opening 24b. Therefore, variation in the width dimension of the superconducting film 18 formed in the regions A and B may be suppressed. Therefore, variation in the areas of the Josephson junctions 30a and 30b may be suppressed.

Furthermore, according to the first embodiment, the mask pattern 20c (third mask pattern) positioned in the region C (third region) on a side opposite to the region A of the substrate 10 relative to the region B includes the opening 22c (fifth opening) and the opening 24c (sixth opening) as in FIG. 6C. As in FIG. 7C, the opening 22c extends inclined to a side opposite to the opening 22a relative to the opening 22b (first opening) along the incident direction of the film formation material when the superconducting film 14 is formed from obliquely above in the -X direction (first oblique direction). The opening 24c is provided apart from the opening 22c in the X-axis direction, and extends in the same direction as the openings 24a and 24b. Therefore, the width dimension of the superconducting film 14 formed by the opening 22c becomes substantially the same as that of the opening 22c. Therefore, variation in the width dimension of the superconducting film 14 formed in the regions A, B, and C may be suppressed. Furthermore, variation in the width dimension of the superconducting film 18 formed in the regions A, B, and C may also be suppressed. Therefore, variation in areas of the Josephson junctions 30a, 30b, and 30c may be suppressed.

Note that, in the first embodiment, a case has been described as an example where the superconducting film 14 is formed by the film formation from obliquely above in the -X direction and the superconducting film 18 is formed by the film formation from obliquely above in the +X direction. Here, although the obliquely above direction is generally at an angle of 45° or the like from the normal direction of the substrate, the film formation may be performed from obliquely above at the different angle from 0° (normal direction) to 60° only on one side.

Note that, in the first embodiment, a case has been described as an example where the openings 22a to 22c of the mask patterns 20a to 20c extend along the incident direction of the film formation material in the film formation of the superconducting film 14 (first film formation). However, the present invention is not limited to this case, and the openings 22a to 22c may extend along the incident direction of the film formation material in the film formation of the superconducting film 18 (second film formation).

### [Second Embodiment]

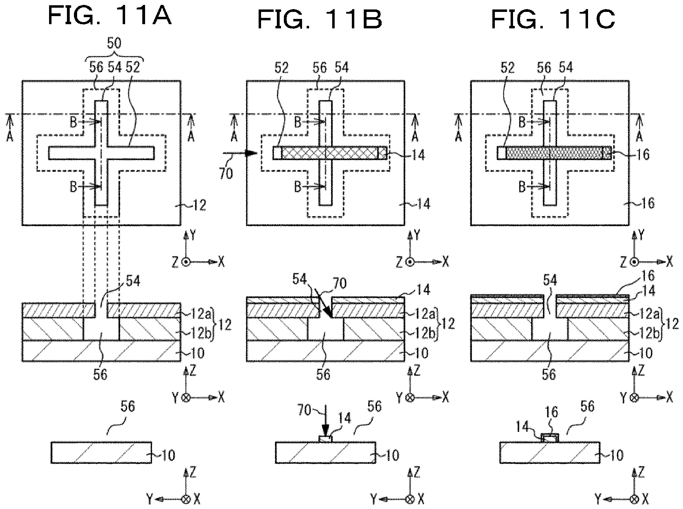

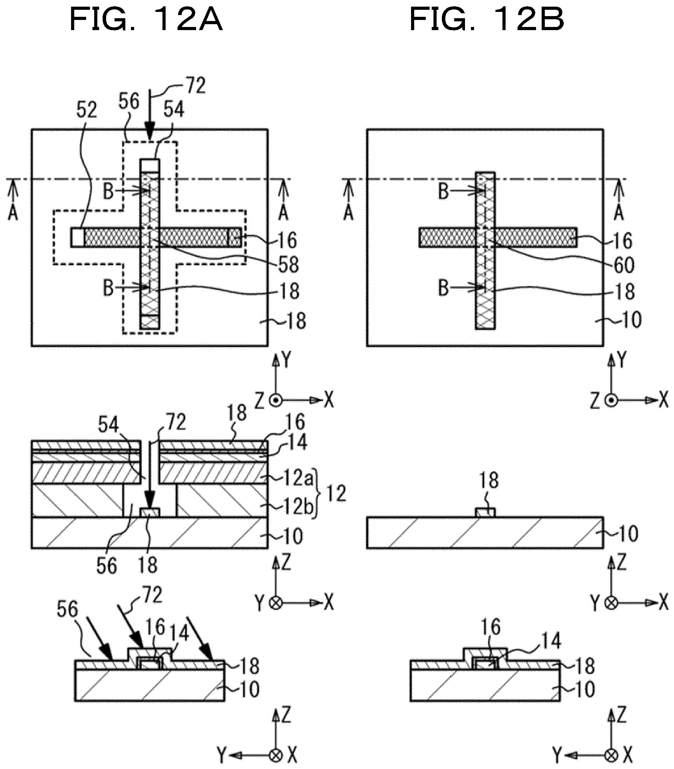

In a second embodiment, a Manhattan Josephson junction device will be described. FIGs. 11A to 12B are views illustrating a method for manufacturing the Manhattan Josephson junction device. Upper views of FIGs. 11A to 12B are plan views illustrating the method for manufacturing the Manhattan Josephson junction device. Middle views are cross-sectional views taken along a line A-A of the upper views, and lower views are cross-sectional views taken along a line B-B of the upper views. In the upper plan views of FIGs. 11B to 12B, a superconducting film 14, an insulating film 16, and a superconducting film 18 formed in a gap 56 are hatched for clarity of the drawings.

As in FIG. 11A, a mask layer 12 is formed on a substrate 10. The mask layer 12 has an upper layer 12a and a lower layer 12b, as in the first embodiment. A mask pattern 50 including an opening 52, an opening 54, and a gap 56 is formed in the mask layer 12. The opening 52 extends in the X-axis direction, the opening 54 intersects the opening 52 and extends in the Y-axis direction, and both are formed in the upper layer 12a. The gap 56 is formed in the lower layer 12b. The gap 56 is positioned below the openings 52 and 54, and has a larger shape than the openings 52 and 54 in plan view.

As in FIG. 11B, the superconducting film 14 is formed above the substrate 10 from obliquely above in the -X direction as indicated by an arrow 70, using the mask layer 12 as a mask. The superconducting film 14 is formed by, for example, the oblique vacuum deposition method. Since the superconducting film 14 is formed above the substrate 10 from obliquely above in the -X direction, by setting a width dimension of the opening 54 to an appropriate size, the superconducting film 14 extending in the Y-axis direction is not formed in the gap 26, and only the superconducting film 14 extending in the X-axis direction is formed. For example, by making the width dimension of the opening 54 smaller than a thickness dimension of the upper layer 12a, it is possible to avoid that the superconducting film 14 extending in the Y-axis direction is formed in the gap 26. The superconducting film 14 is formed to be shifted in the +X direction relative to the opening 52.

As in FIG. 11C, while maintaining a vacuum state when the superconducting film 14 is formed, oxygen is introduced into a chamber to oxidize a surface of the superconducting film 14, and the insulating film 16 is formed at the surface of the superconducting film 14.

As in FIG. 12A, the superconducting film 18 is formed above the substrate 10 from obliquely above in the +Y direction as indicated by an arrow 72, using the mask layer 12 as the mask. The superconducting film 18 is formed by, for example, the oblique vacuum deposition method. Since the superconducting film 18 is formed above the substrate 10 from obliquely above in the +Y direction, by setting a width dimension of the opening 52 to an appropriate size, the superconducting film 18 extending in the X-axis direction is not formed in the gap 56, and only the superconducting film 18 extending in the Y-axis direction is formed. For example, by making the width dimension of the opening 52 smaller than the thickness dimension of the upper layer 12a, it is possible to avoid that the superconducting film 18 extending in the X-axis direction is formed in the gap 56. The superconducting film 18 is formed to be shifted in the -Y direction relative to the opening 54. Therefore, a region 58 in which the superconducting film 14 extending in the X-axis direction and the superconducting film 18 extending in the Y-axis direction overlap each other via the insulating film 16 is formed.

As in FIG. 12B, the mask layer 12, and the superconducting film 14, the insulating film 16, and the superconducting film 18 formed above the mask layer 12 are removed by the lift-off method. The region 58 in which the superconducting film 14 extending in the X-axis direction and the superconducting film 18 extending in the Y-axis direction overlap each other via the insulating film 16 becomes a Josephson junction 60.

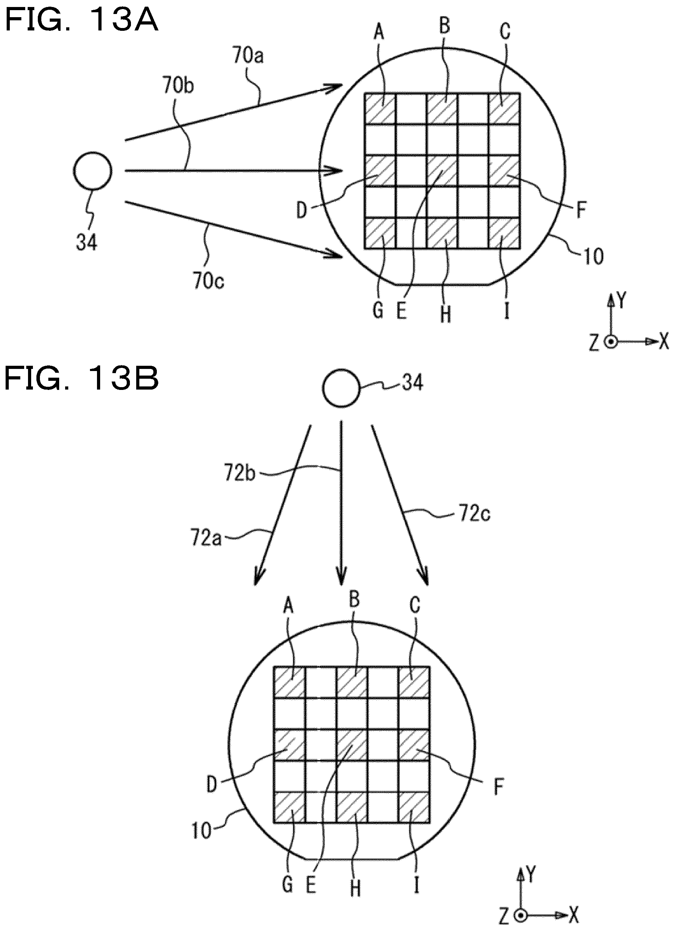

A problem occurring in the Manhattan Josephson junction device will be described with reference to FIGs. 13A to 15I. In FIGs. 13A and 13B, film formation of the superconducting films 14 and 18 above the wafer-like substrate 10 by the oblique vacuum deposition method in the Manhattan Josephson junction device is illustrated. As in FIG. 13A, by vaporizing or sublimating a deposition material of a deposition source 34 positioned in the -X direction relative to the substrate 10, the deposition material is made incident to the substrate 10 from obliquely above in the -X direction to form the superconducting film 14. At this time, the deposition source 34 is not positioned at infinity relative to the substrate 10, but is placed at a realistic distance of, for example, about 50 cm from the substrate 10. Thus, as indicated by arrows 70a, 70b, and 70c, an incident angle of the deposition material of the deposition source 34 is different in the Y-axis direction of the substrate 10. In other words, the incident angle of the deposition material of the deposition source 34 is different in regions A, B, and C positioned on the side of the +Y direction, regions D, E, and F positioned at a center in the Y-axis direction, and regions G, H, and I positioned on the side of the -Y direction in the substrate 10. Similarly, as in FIG. 13B, by vaporizing or sublimating the deposition material of the deposition source 34 positioned in the +Y direction relative to the substrate 10, the deposition material is made incident to the substrate 10 from obliquely above in the +Y direction to form the superconducting film 18. Thus, as indicated by arrows 72a, 72b, and 72c, the incident angle of the deposition material of the deposition source 34 is different in the X-axis direction of the substrate 10. In other words, the incident angle of the deposition material of the deposition source 34 is different in the regions A, D, and G positioned on the side of the -X direction, the regions B, E, and H positioned at the center in the X-axis direction, and the regions C, F, and I positioned on the side of the +X direction in the substrate 10.

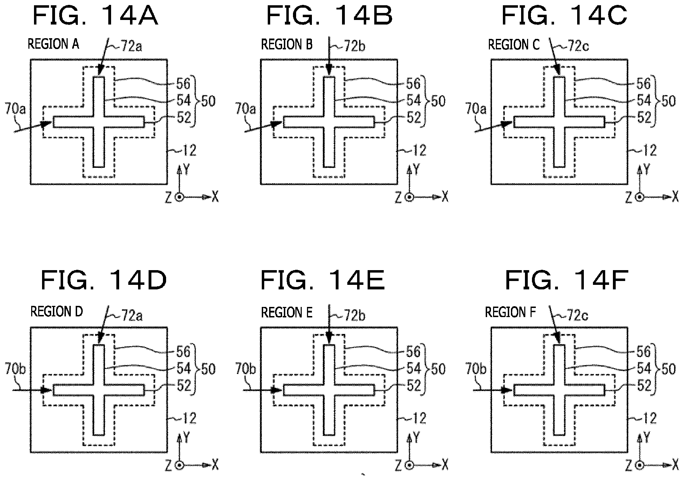

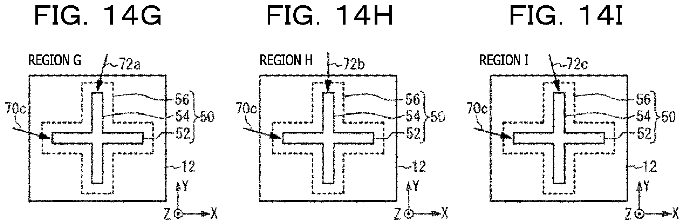

In FIGs. 14A to 14I, the incident angle of the deposition material to the mask pattern 50 of the regions A to I in FIGs. 13A and 13B is illustrated. As in FIGs. 14A to 14I, it is assumed that the opening 52 included in the mask pattern 50 extends in the X-axis direction and the opening 54 extends in the Y-axis direction in all of the regions A to I. In this case, as in FIGs. 14D to 14F, with respect to the regions D, E, and F positioned at the center in the Y-axis direction in the substrate 10, the deposition material is incident to the opening 52 from a direction substantially parallel to the X-axis direction as indicated by the arrow 70b. On the other hand, as in FIGs. 14A to 14C, with respect to the regions A, B, and C positioned on the side of the +Y direction in the substrate 10, the deposition material is incident to the opening 52 from a direction inclined in the -Y direction relative to the X-axis direction as indicated by the arrow 70a. As in FIGs. 14G to 14I, with respect to the regions G, H, and I positioned on the side of the -Y direction in the substrate 10, the deposition material is incident to the opening 52 from a direction inclined in the +Y direction relative to the X-axis direction as indicated by the arrow 70c.

Furthermore, as in FIGs. 14B, 14E, and 14H, with respect to the regions B, E, and H positioned at the center in the X-axis direction in the substrate 10, the deposition material is incident to the opening 54 from a direction substantially parallel to the Y-axis direction as indicated by the arrow 72b. On the other hand, as in FIGs. 14A, 14D, and 14G, with respect to the regions A, D, and G positioned on the side of the -X direction in the substrate 10, the deposition material is incident to the opening 54 from a direction inclined in the +X direction relative to the Y-axis direction as indicated by the arrow 72a. As in FIGs. 14C, 14F, and 14I, with respect to the regions C, F, and I positioned on the side of the +X direction in the substrate 10, the deposition material is incident to the opening 54 from a direction inclined in the -X direction relative to the Y-axis direction as indicated by the arrow 72c.

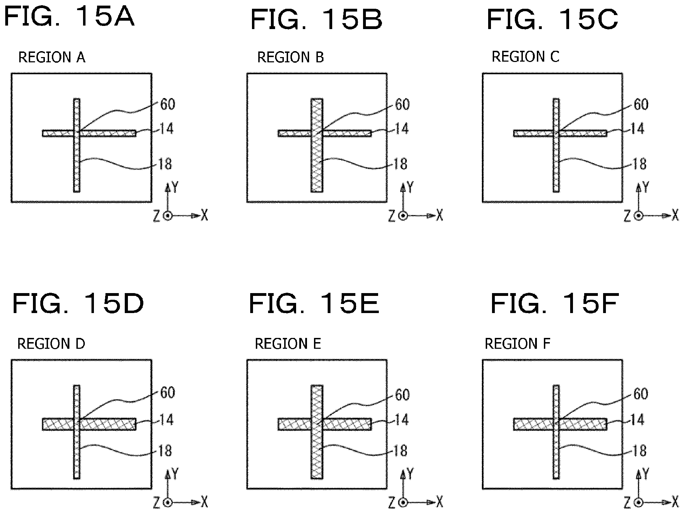

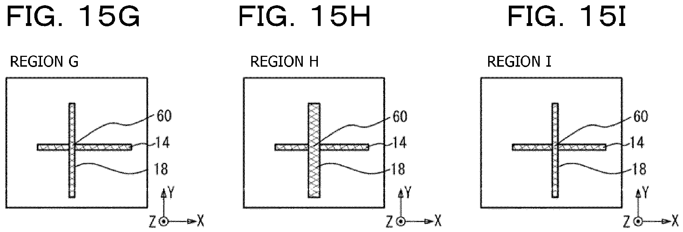

In FIGs. 15A to 15I, Josephson junction devices formed in the regions A to I in FIGs. 13A and 13B are illustrated. Note that, in FIGs. 15A to 15I, the superconducting film 14 is illustrated through the insulating film 16. As illustrated in FIGs. 14D to 14F, in the regions D, E, and F, the deposition material is incident to the opening 52 extending in the X-axis direction from the direction substantially parallel to the X-axis direction. Thus, as in FIGs. 15D to 15F, the superconducting film 14 formed to extend in the X-axis direction is formed to have substantially the same width as the width of the opening 52. On the other hand, as illustrated in FIGs. 14A to 14C, in the regions A, B, and C, the deposition material is incident to the opening 52 extending in the X-axis direction from the direction inclined in the -Y direction relative to the X-axis direction. Thus, as in FIGs. 15A to 15C, the superconducting film 14 formed to extend in the X-axis direction is formed to be narrower than the width of the opening 52. As illustrated in FIGs. 14G to 14I, in the regions G, H, and I, the deposition material is incident to the opening 52 extending in the X-axis direction from the direction inclined in the +Y direction relative to the X-axis direction. Thus, as in FIGs. 15G to 15I, the superconducting film 14 formed to extend in the X-axis direction is formed to be narrower than the width of the opening 52.

Furthermore, as illustrated in FIGs. 14B, 14E, and 14H, in the regions B, E, and H, the deposition material is incident to the opening 54 extending in the Y-axis direction from the direction substantially parallel to the Y-axis direction. Thus, as in FIGs. 15B, 15E, and 15H, the superconducting film 18 formed to extend in the Y-axis direction is formed to have substantially the same width as the width of the opening 54. On the other hand, as illustrated in FIGs. 14A, 14D, and 14G, in the regions A, D, and G, the deposition material is incident to the opening 54 extending in the Y-axis direction from the direction inclined in the +X direction relative to the Y-axis direction. Thus, as in FIGs. 15A, 15D, and 15G, the superconducting film 18 formed to extend in the Y-axis direction is formed to be narrower than the width of the opening 54. As illustrated in FIGs. 14C, 14F, and 14I, in the regions C, F, and I, the deposition material is incident to the opening 54 extending in the Y-axis direction from the direction inclined in the -X direction relative to the Y-axis direction. Thus, as in FIGs. 15C, 15F, and 15I, the superconducting film 18 formed to extend in the Y-axis direction is formed to be narrower than the width of the opening 54.

Characteristics of the Josephson junction device are affected by an area of the Josephson junction 60 in which the superconducting film 14 and the superconducting film 18 overlap each other via the insulating film 16. When the area of the Josephson junction 60 varies, the characteristics of the Josephson junction device vary, which becomes a factor of lowering fidelity of a qubit. Therefore, as in FIGs. 15A to 15I, when the area of the Josephson junction 60 varies in the substrate 10, the characteristics of the Josephson junction device vary, and as a result, the fidelity of the qubit is lowered.

Thus, a manufacturing method capable of suppressing variation in the area of the Josephson junction 60 in the substrate 10 small in the Manhattan Josephson junction device will be described below.

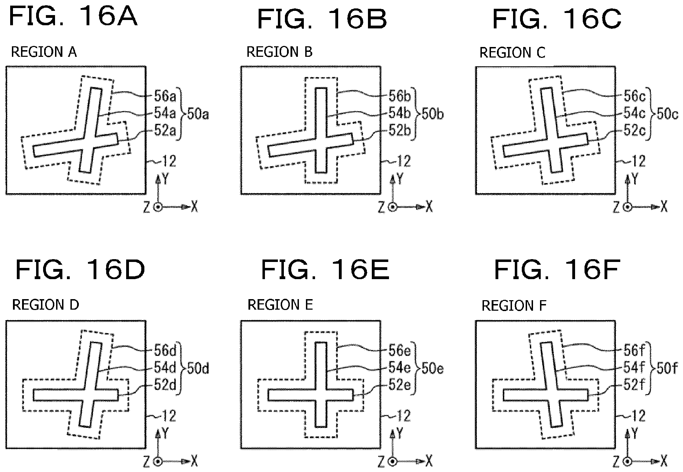

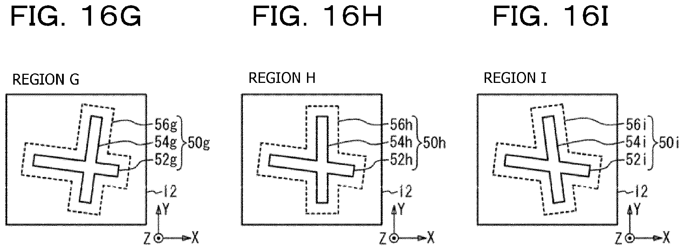

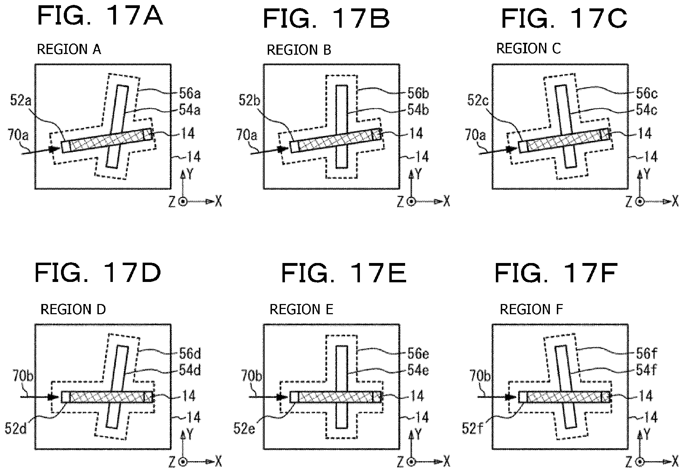

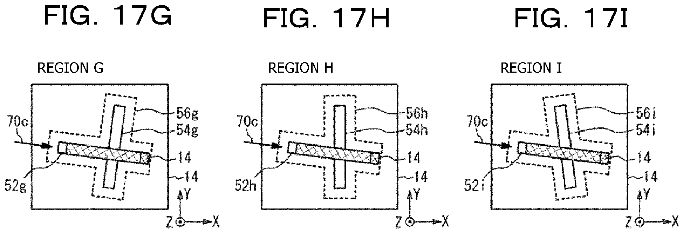

FIGs. 16A to 20I are plan views illustrating a method for manufacturing the Josephson junction device according to the second embodiment. In each drawing of FIGs. 16 to 20, A is a plan view of a portion corresponding to the region A in FIGs. 13A and 13B, B is a plan view of a portion corresponding to the region B, C is a plan view of a portion corresponding to the region C, and D is a plan view of a portion corresponding to the region D. E is a plan view of a portion corresponding to the region E, F is a plan view of a portion corresponding to the region F, G is a plan view of a portion corresponding to the region G, H is a plan view of a portion corresponding to the region H, and I is a plan view of a portion corresponding to the region I. In FIGs. 17A to 20C, the superconducting film 14, the insulating film 16, and the superconducting film 18 formed in gaps 56a to 56i are illustrated by hatching for clarity of the drawings.

As in FIGs. 16A to 16I, the mask layer 12 having the upper layer 12a and the lower layer 12b is formed on the wafer-like substrate 10 (see also FIGs. 11A, 13A, and 13B). In the mask layer 12, mask patterns 50a to 50i are formed in the regions A to I. As in FIGs. 16A to 16C, the mask patterns 50a, 50b, and 50c formed in the regions A, B, and C include openings 52a, 52b, and 52c extending inclined in the +Y direction from the -X direction toward the +X direction. Furthermore, as in FIG. 16A, the mask pattern 50a includes, in addition to the opening 52a, an opening 54a extending inclined in the +X direction from the -Y direction toward the +Y direction, and the gap 56a. The gap 56a has a shape larger than the openings 52a and 54a in plan view, and is formed below the openings 52a and 54a. As in FIG. 16B, the mask pattern 50b includes, in addition to the opening 52b, an opening 54b extending in the Y-axis direction, and the gap 56b. The gap 56b has a shape larger than the openings 52b and 54b in plan view, and is formed below the openings 52b and 54b. As in FIG. 16C, the mask pattern 50c includes, in addition to the opening 52c, an opening 54c extending inclined in the -X direction from the -Y direction toward the +Y direction, and the gap 56c. The gap 56c has a shape larger than the openings 52c and 54c in plan view, and is formed below the openings 52c and 54c.

As in FIGs. 16D to 16F, the mask patterns 50d, 50e, and 50f formed in the regions D, E, and F include openings 52d, 52e, and 52f extending in the X-axis direction. Furthermore, as in FIG. 16D, the mask pattern 50d includes, in addition to the opening 52d, an opening 54d extending inclined in the +X direction from the - Y direction toward the +Y direction, and the gap 56d. The gap 56d has a shape larger than the openings 52d and 54d in plan view, and is formed below the openings 52d and 54d. As in FIG. 16E, the mask pattern 50e includes, in addition to the opening 52e, an opening 54e extending in the Y-axis direction, and the gap 56e. The gap 56e has a shape larger than the openings 52e and 54e in plan view, and is formed below the openings 52e and 54e. As in FIG. 16F, the mask pattern 50f includes, in addition to the opening 52f, an opening 54f extending inclined in the -X direction from the -Y direction toward the +Y direction, and the gap 56f. The gap 56f has a shape larger than the openings 52f and 54f in plan view, and is formed below the openings 52f and 54f.

As in FIGs. 16G to 16I, the mask patterns 50g, 50h, and 50i formed in the regions G, H, and I include openings 52g, 52h, and 52i extending inclined in the -Y direction from the -X direction toward the +X direction. Furthermore, as in FIG. 16G, the mask pattern 50g includes, in addition to the opening 52g, an opening 54g extending inclined in the +X direction from the -Y direction toward the +Y direction, and the gap 56g. The gap 56g has a shape larger than the openings 52g and 54g in plan view, and is formed below the openings 52g and 54g. As in FIG. 16H, the mask pattern 50h includes, in addition to the opening 52h, an opening 54h extending in the Y-axis direction, and the gap 56h. The gap 56h has a shape larger than the openings 52h and 54h in plan view, and is formed below the openings 52h and 54h. As in FIG. 16I, the mask pattern 50i includes, in addition to the opening 52i, an opening 54i extending inclined in the -X direction from the -Y direction toward the +Y direction, and the gap 56i. The gap 56i has a shape larger than the openings 52i and 54i in plan view, and is formed below the openings 52i and 54i.

The openings 52a to 52i mutually have the same width dimension and the same length dimension. Similarly, the openings 54a to 54i mutually have the same width dimension and length dimension. The openings 52a to 52i and the openings 54a to 54i have, for example, the same width dimension and length dimension, but at least one of the width dimension and the length dimension may be different.

As in FIGs. 17A to 17I, the superconducting film 14 is formed above the substrate 10 from obliquely above in the -X direction using the mask layer 12 as the mask by using the oblique vacuum deposition method. For example, an aluminum (Al) film is formed as the superconducting film 14. As in FIGs. 17A to 17C, in the regions A, B, and C, the deposition material is incident to the openings 52a, 52b, and 52c from the direction inclined in the -Y direction relative to the X-axis direction as indicated by the arrow 70a. The openings 52a, 52b, and 52c are inclined in the +Y direction from the -X direction toward the +X direction, and are formed along the incident direction of the deposition material. Thus, the superconducting film 14 having substantially the same width dimension as the openings 52a, 52b, and 52c is formed in the gaps 56a, 56b, and 56c. The superconducting film 14 formed in the gaps 56a, 56b, and 56c by the openings 52a, 52b, and 52c is formed to be shifted toward the side of the +X direction relative to the openings 52a, 52b, and 52c. Furthermore, by setting the width dimension of the openings 54a, 54b, and 54c to an appropriate size, the superconducting film 14 extending in the Y-axis direction is not formed in the gaps 56a, 56b, and 56c. For example, the width dimension of the openings 54a, 54b, and 54c is made smaller than the thickness dimension of the upper layer 12a of the mask layer 12.

As in FIGs. 17D to 17F, in the regions D, E, and F, the deposition material is incident to the openings 52d, 52e, and 52f, substantially parallel to the X-axis direction as indicated by the arrow 70b. The openings 52d, 52e, and 52f extend in the X-axis direction, and are formed along the incident direction of the deposition material. Thus, the superconducting film 14 having substantially the same width dimension as the openings 52d, 52e, and 52f is formed in the gaps 56d, 56e, and 56f. The superconducting film 14 formed in the gaps 56d, 56e, and 56f by the openings 52d, 52e, and 52f is formed to be shifted toward the side of the +X direction relative to the openings 52d, 52e, and 52f. Furthermore, by setting the width of the openings 54d, 54e, and 54f to an appropriate size, the superconducting film 14 extending in the Y-axis direction is not formed in the gaps 56d, 56e, and 56f. For example, the width dimension of the openings 54d, 54e, and 54f is made smaller than the thickness dimension of the upper layer 12a of the mask layer 12.

As in FIGs. 17G to 17I, in the regions G, H, and I, the deposition material is incident to the openings 52g, 52h, and 52i from the direction inclined in the +Y direction relative to the X-axis direction as indicated by the arrow 70c. The openings 52g, 52h, and 52i are inclined in the -Y direction from the -X direction toward the +X direction, and are formed along the incident direction of the deposition material. Thus, the superconducting film 14 having substantially the same width dimension as the openings 52g, 52h, and 52i is formed in the gaps 56g, 56h, and 56i. The superconducting film 14 formed in the gaps 56g, 56h, and 56i by the openings 52g, 52h, and 52i is formed to be shifted toward the side of the +X direction relative to the openings 52g, 52h. and 52i. Furthermore, by setting the width dimension of the openings 54g, 54h, and 54i to an appropriate size, the superconducting film 14 extending in the Y-axis direction is not formed in the gaps 56g, 56h, and 56i. For example, the width dimension of the openings 54g, 54h, and 54i is made smaller than the thickness dimension of the upper layer 12a of the mask layer 12.

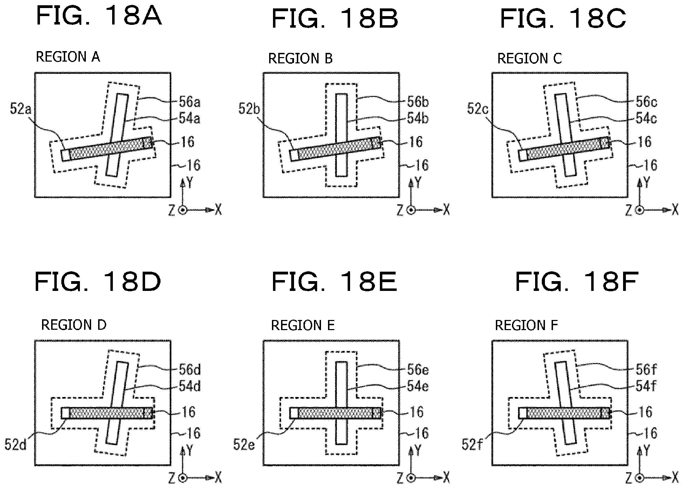

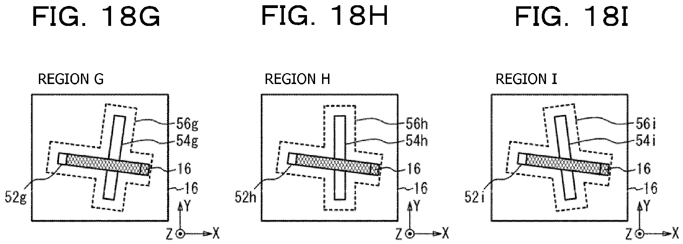

As in FIGs. 18A to 18I, while maintaining the vacuum state when the superconducting film 14 is formed, oxygen is introduced into the chamber to oxidize the surface of the superconducting film 14, and the insulating film 16 is formed at the surface of the superconducting film 14.

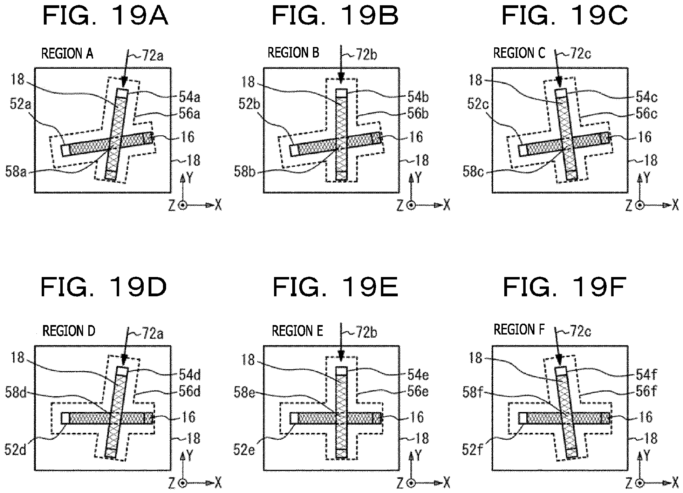

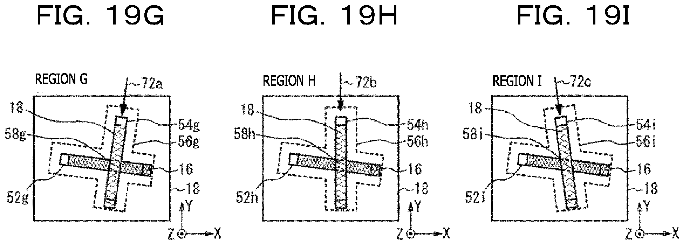

As in FIGs. 19A to 19I, the superconducting film 18 is formed above the substrate 10 from obliquely above in the +Y direction using the mask layer 12 as the mask by using the oblique vacuum deposition method. For example, an aluminum (Al) film is formed as the superconducting film 18. As in FIGs. 19A, 19D, and 19G, in the regions A, D, and G, the deposition material is incident to the openings 54a, 54d, and 54g from the direction inclined in the +X direction relative to the Y-axis direction as indicated by the arrow 72a. The openings 54a, 54d, and 54g are inclined in the -X direction from the +Y direction toward the -Y direction, and are formed along the incident direction of the deposition material. Thus, the superconducting film 18 having substantially the same width dimension as the openings 54a, 54d, and 54g is formed in the gaps 56a, 56d, and 56g. The superconducting film 18 formed in the gaps 56a, 56d, and 56g by the openings 54a, 54d, and 54g is formed to be shifted toward the side of the -Y direction relative to the openings 54a, 54d, and 54g. Furthermore, by setting the width dimension of the openings 52a, 52d, and 52g to an appropriate size, the superconducting film 18 extending in the X-axis direction is not formed in the gaps 56a, 56d, and 56g. For example, the width dimension of the openings 52a, 52d, and 52g is made smaller than the thickness dimension of the upper layer 12a of the mask layer 12.

As in FIGs. 19B, 19E, and 19H, in the regions B, E, and H, the deposition material is incident to the openings 54b, 54e, and 54h, substantially parallel to the Y-axis direction as indicated by the arrow 72b. The openings 54b, 54e, and 54h extend in the Y-axis direction, and are formed along the incident direction of the deposition material. Thus, the superconducting film 18 having substantially the same width as the openings 54b, 54e, and 54h is formed in the gaps 56b, 56e, and 56h. The superconducting film 18 formed in the gaps 56b, 56e, and 56h by the openings 54b, 54e, and 54h is formed to be shifted toward the side of the -Y direction relative to the openings 54b, 54e, and 54h. Furthermore, by setting the width of the openings 52b, 52e, and 52h to an appropriate size, the superconducting film 18 extending in the X-axis direction is not formed in the gaps 56b, 56e, and 56h. For example, the width dimension of the openings 52b, 52e, and 52h is made smaller than the thickness dimension of the upper layer 12a of the mask layer 12.

As in FIGs. 19C, 19F, and 19I, in the regions C, F, and I, the deposition material is incident to the openings 54c, 54f, and 54i from the direction inclined in the -X direction relative to the Y-axis direction as indicated by the arrow 72c. The openings 54c, 54f, and 54i are inclined in the +X direction from the +Y direction toward the -Y direction, and are formed along the incident direction of the deposition material. Thus, the superconducting film 18 having substantially the same width dimension as the openings 54c, 54f, and 54i is formed in the gaps 56c, 56f, and 56i. The superconducting film 18 formed in the gaps 56c, 56f, and 56i by the openings 54c, 54f, and 54i is formed to be shifted toward the side of the -Y direction relative to the openings 54c, 54f, and 54i. Furthermore, by setting the width of the openings 52c, 52f, and 52i to an appropriate size, the superconducting film 18 extending in the X-axis direction is not formed in the gaps 56c, 56f, and 56i. For example, the width dimension of the openings 52c, 52f, and 52i is made smaller than the thickness dimension of the upper layer 12a of the mask layer 12.

In the respective regions A to I, regions 58a to 58i in which the superconducting film 14 extending in the X-axis direction and the superconducting film 18 extending in the Y-axis direction overlap each other via the insulating film 16 are formed.

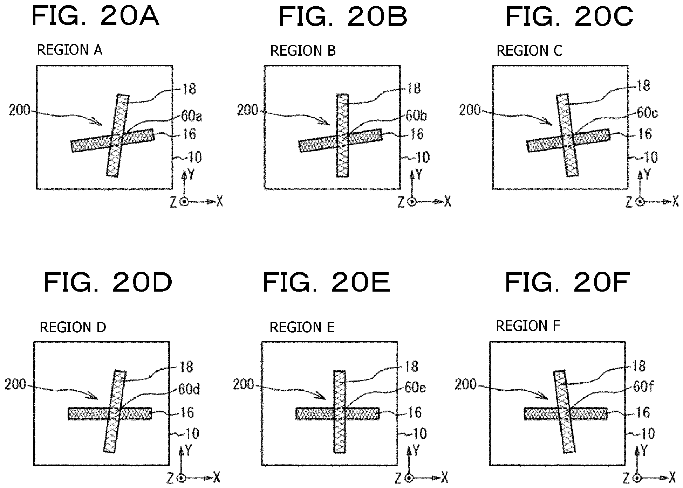

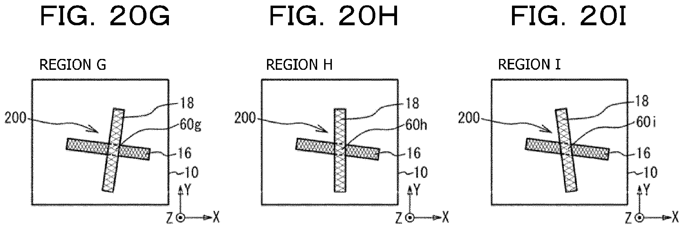

As in FIGs. 20A to 20I, the mask layer 12, and the superconducting film 14, the insulating film 16, and the superconducting film 18 formed above the mask layer 12 are removed by the lift-off method. The regions 58a to 58i in which the superconducting film 14 extending in the X-axis direction and the superconducting film 18 extending in the Y-axis direction overlap each other via the insulating film 16 become Josephson junctions 60a to 60i. Therefore, a Manhattan Josephson junction device 200 is formed in each of the regions A to I.

As described above, according to the second embodiment, the mask pattern 50e (first mask pattern) positioned in the region E (first region) of the substrate 10 includes the opening 52e (first opening) and the opening 54e (second opening) as in FIG. 16E. As in FIG. 17E, the opening 52e extends along the incident direction of the film formation material when the superconducting film 14 is formed from obliquely above in the -X direction (first oblique direction). The opening 54e extends while intersecting the opening 52e. The mask pattern 50b (second mask pattern) positioned in the region B (second region) positioned closer to an end of the substrate 10 than the region E includes the opening 52b (third opening) and the opening 54b (fourth opening) as in FIG. 16B. As in FIG. 17B, the opening 52b extends inclined relative to the opening 52e (first opening), along the incident direction of the film formation material when the superconducting film 14 is formed from obliquely above in the -X direction (first oblique direction). The opening 54b extends while intersecting the opening 52b. Therefore, the width dimension of the superconducting film 14 formed by the openings 52b and 52e becomes substantially the same as the width dimension of the openings 52b and 52e, and variation in the width dimension of the superconducting film 14 formed in the regions B and E may be suppressed. Therefore, variation in areas of the Josephson junctions 60b and 60e may be suppressed.

Furthermore, according to the second embodiment, the width dimension of the opening 52e of the mask pattern 50e formed in the region E is the same as the width dimension of the opening 52b of the mask pattern 50b formed in the region B. Therefore, the width dimension of the superconducting film 14 formed by the opening 52b and the width dimension of the superconducting film 14 formed by the opening 52e become substantially the same. Therefore, variation in the areas of the Josephson junctions 60b and 60e may be suppressed. The fact that the width dimensions are the same also includes a case where the width dimensions are different to an extent of a manufacturing error.

Furthermore, according to the second embodiment, the openings 52b and 54b of the mask pattern 50b are formed in the upper layer 12a of the mask layer 12, and the gap 56b is formed below the openings 52b and 54b in the lower layer 12b in the shape larger than the openings 52b and 54b in plan view. Similarly, the openings 52e and 54e of the mask pattern 50e are formed in the upper layer 12a of the mask layer 12, and the gap 56e is formed below the openings 52e and 54e in the lower layer 12b in the shape larger than the openings 52e and 54e in plan view. By using such mask patterns 50b and 50e, the Josephson junction devices 200 as in FIGs. 20B and 20E are formed.

Furthermore, according to the second embodiment, the film formation of the superconducting film 14 is performed from obliquely above in the -X direction (first oblique direction), and the film formation of the superconducting film 18 is performed from obliquely above in the +Y direction (second oblique direction) that is a direction intersecting the film formation of the superconducting film 14 (for example, a direction different by 90°) relative to the substrate 10. The mask patterns 50b and 50e are provided side by side in the Y-axis direction. The opening 52b of the mask pattern 50b and the opening 52e of the mask pattern 50e extend along the incident direction of the film formation material in the film formation (first film formation) from obliquely above in the -X direction. The opening 54e of the mask pattern 50e extends along the incident direction of the film formation material in the film formation (second film formation) from obliquely above in the +Y direction. The opening 54b of the mask pattern 50b extends in the same direction as the opening 54e of the mask pattern 50e along the incident direction of the film formation material in the film formation from obliquely above in the +Y direction (second film formation). Therefore, the width dimension of the superconducting film 14 formed by the openings 52b and 52e becomes substantially the same as the width dimension of the openings 52b and 52e. The width dimension of the superconducting film 18 formed by the openings 54b and 54e becomes substantially the same as the width dimension of the openings 54b and 54e. Therefore, variation in the areas of the Josephson junctions 60b and 60e may be suppressed.

Furthermore, according to the second embodiment, the mask pattern 50h (third mask pattern) positioned in the region H (third region) on a side opposite to the region B of the substrate 10 relative to the region E includes the opening 52h (fifth opening) and the opening 54h (sixth opening) as in FIG. 16B. As in FIG. 17H, the opening 52h extends inclined to a side opposite to the opening 52b relative to the opening 52e (first opening) along the incident direction of the film formation material in the film formation of the superconducting film 14 (first film formation) from obliquely above in the -X direction. As in FIG. 19H, the opening 54h intersects the opening 52h, and extends in the same direction as the openings 54b and 54e along the incident direction of the film formation material when the superconducting film 18 is formed (second film formation) from the +Y direction. Therefore, the width dimension of the superconducting film 14 formed by the opening 52h becomes substantially the same as the width dimension of the opening 52h, and the width dimension of the superconducting film 18 formed by the opening 54h becomes substantially the same as the width dimension of the opening 54h. Therefore, variation in the width dimension of the superconducting films 14 and 18 formed in the region H relative to the width dimension of the superconducting films 14 and 18 formed in the regions Band E is suppressed, and variation in areas of the Josephson junctions 60b, 60e, and 60h may be suppressed.

Furthermore, according to the second embodiment, the mask pattern 50f (fourth mask pattern) positioned in the region F (fourth region) having a positional relationship of 90° with the region B relative to the center of the substrate 10 includes the opening 52f (seventh opening) and the opening 54f (eighth opening) as in FIG. 16F. As in FIG. 17F, the opening 52f extends in the same direction as the opening 52e (first opening) along the incident direction of the film formation material in the film formation of the superconducting film 14 (first film formation) from obliquely above in the -X direction. As in FIG. 19F, the opening 54f intersects the opening 52f, and extends inclined relative to the opening 54e (second opening) along the incident direction of the film formation material in the film formation of the superconducting film 18 (second film formation) from obliquely above in the +Y direction. Therefore, the width dimension of the superconducting film 14 formed by the opening 52f becomes substantially the same as the width dimension of the opening 52f, and the width dimension of the superconducting film 18 formed by the opening 54f becomes substantially the same as the width dimension of the opening 54f. Therefore, variation in the width dimension of the superconducting films 14 and 18 formed in the region F relative to the width dimension of the superconducting films 14 and 18 formed in the regions B and E is suppressed, and variation in areas of the Josephson junctions 60b, 60e, and 60f may be suppressed.

Furthermore, according to the second embodiment, the mask pattern 50c (fifth mask pattern) positioned in the region C (fifth region) having a positional relationship of 45° with the region B relative to the center of the substrate 10 includes the opening 52c (ninth opening) and the opening 54c (tenth opening) as in FIG. 16C. As in FIG. 17C, the opening 52c extends inclined relative to the opening 52e (first opening) along the incident direction of the film formation material in the film formation of the superconducting film 14 (first film formation) from obliquely above in the -X direction. As in FIG. 19C, the opening 54c intersects the opening 52c, and extends inclined relative to the opening 54e (second opening) along the incident direction of the film formation material in the film formation of the superconducting film 18 (second film formation) from obliquely above in the +Y direction. Therefore, the width dimension of the superconducting film 14 formed by the opening 52c becomes substantially the same as the width dimension of the opening 52c, and the width dimension of the superconducting film 18 formed by the opening 54c becomes substantially the same as the width dimension of the opening 54c. Therefore, variation in the width dimension of the superconducting films 14 and 18 formed in the region C relative to the width dimension of the superconducting films 14 and 18 formed in the regions B and E is suppressed, and variation in areas of the Josephson junctions 60b, 60e, and 60c may be suppressed.

Note that, in the second embodiment, a case has been described as an example where the superconducting film 14 is formed by the film formation from obliquely above in the -X direction and the superconducting film 18 is formed by the film formation from obliquely above in the +Y direction. Here, although the obliquely above direction is generally at an angle of 45° or the like from the normal direction of the substrate, the film formation may be performed from obliquely above at an angle of 30° to 60° from a relationship with the thickness of the upper layer 12a of the mask layer 12.

Note that, in the first and second embodiments, a case has been described as an example where the superconducting films 14 and 18 are formed using the oblique deposition method. However, in a case where the superconducting films 14 and 18 are formed by film formation from the oblique direction, the superconducting films 14 and 18 may be formed by a method other than the oblique deposition. Furthermore, the substrate 10 may be other than the silicon substrate, and may be, for example. a sapphire substrate or the like. The superconducting films 14 and 18 may be other than the aluminum (Al) film, and may be, for example, a niobium (Nb) film, a niobium nitride (NbN) film, a tantalum (Ta) film, a tantalum nitride (TaN) or a titanium nitride (TiN) film, or the like. The insulating film 16 may be other than the aluminum oxide.

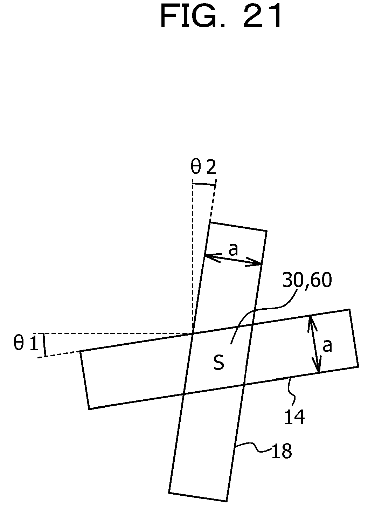

Here, a relationship between an intersection angle between the superconducting film 14 and the superconducting film 18 and the area of the Josephson junctions 30 and 60 will be described. FIG. 21 is a plan view of a model used to examine a correlation between the intersection angle between the superconducting film 14 and the superconducting film 18 and the area of the Josephson junctions 30 and 60. As in FIG. 21, a case where the superconducting film 14 and the superconducting film 18 are orthogonal to each other is used as a reference, and an angle at which the superconducting film 14 is inclined from the reference is defined as θ1, and an angle at which the superconducting film 18 is inclined from the reference is defined as θ2. The area of the Josephson junctions 30 and 60 is defined as S, and the widths of the superconducting films 14 and 18 are both defined as a.

In Table 1, a relationship among a sum of the angle θ1 and the angle θ2, the area S of the Josephson junctions 30 and 60, a change rate P in the area S with the angle θ1+ the angle θ2 as a reference, and a reciprocal 1/S of the area S is indicated. As indicated in Table 1, the larger the sum of the angle θ1 and the angle θ2, the larger the area S of the Josephson junctions 30 and 60, and as a result, the reciprocal 1/S of the area S decreases. The reciprocal 1/S of the area S is proportional to a resistance. In a case where the angle θ1 + the angle θ2 is 8° or less, the change rate of the reciprocal 1/S of the area S falls within 1% or less.

**[Table 1]**

| θ₁ + θ₂ [°] | S [nm²] | change rate P [%] | 1/S [× a⁻²] |
|---|---|---|---|
| 0 | a² × 1 | 0 | 1 |
| 2 | a² × 1.00061 | 0.061 | 0.99939 |
| 4 | a² × 1.00244 | 0.244 | 0.99757 |
| 6 | a² × 1.00551 | 0.551 | 0.99452 |
| 8 | a² × 1.00983 | 0.983 | 0.99027 |
| 10 | a² × 1.01543 | 1.543 | 0.98481 |

By the manufacturing methods described in the first and second embodiments, the angle θ1 + θ2 between the superconducting film 14 and the superconducting film 18 in the plurality of Josephson junction devices 100 and 200 formed in the substrate 10 may be fallen within 8° or less. For example, in a case where a 7.62 cm (3-inch) wafer is used as the substrate 10 and a distance between the substrate 10 and the deposition source 34 is about 50 cm, the angle θ1 + θ2 falls within 8° or less. Therefore, the change rate in the reciprocal 1/S of the area S of the Josephson junctions 30 and 60 of the plurality of Josephson junction devices 100 and 200 formed in the substrate 10 may be fallen within 1% or less. When the change rate in the reciprocal 1/S falls within 1% or less, a change in the characteristics of the Josephson junction devices 100 and 200 falls within an allowable range.

Therefore, in the first embodiment, a ratio of the area of the Josephson junction 30a formed by the mask pattern 20a (second mask pattern) to the area of the Josephson junction 30b formed by the mask pattern 20b (first mask pattern) is 99% or more and 101% or less. Therefore, it is possible to suppress variation in the characteristics between the Josephson junction device 100 having the Josephson junction 30a and the Josephson junction device 100 having the Josephson junction 30b. Furthermore, in the second embodiment, a ratio of the area of the Josephson junction 60b formed by the mask pattern 50b (second mask pattern) to the area of the Josephson junction 60e formed by the mask pattern 50e (first mask pattern) is 99% or more and 101% or less. Therefore, it is possible to suppress variation in the characteristics between the Josephson junction device 200 having the Josephson junction 60b and the Josephson junction device 200 having the Josephson junction 60e.

### [Third Embodiment]

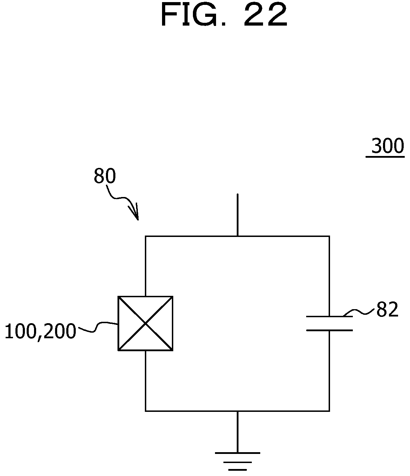

FIG. 22 is a circuit diagram of a qubit 300 according to a third embodiment. As in FIG. 22, the qubit 300 includes a transmon 80 including the Josephson junction device 100 of the first embodiment or the Josephson junction device 200 of the second embodiment, and a capacitor 82 coupled in parallel to the Josephson junction device 100 or 200.

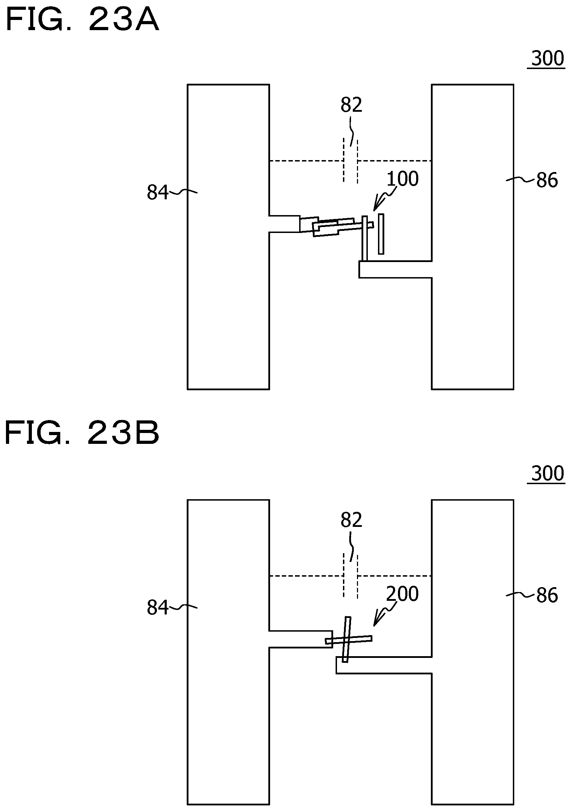

FIGs. 23A and 23B are plan views illustrating the qubit 300 according to the third embodiment. FIG. 23A includes the Josephson junction device 100 of the first embodiment, and FIG. 23B includes the Josephson junction device 200 of the second embodiment. As in FIG. 23A, the Josephson junction device 100 is formed by the manufacturing method of the first embodiment, and the capacitor 82 coupled in parallel to the Josephson junction device 100 is formed. The capacitor 82 is formed between electrode films 84 and 86 coupled to the Josephson junction device 100 by making the electrode films 84 and 86 face each other, for example. Similarly, as in FIG. 23B, the Josephson junction device 200 is formed by the manufacturing method of the second embodiment, and the capacitor 82 coupled in parallel to the Josephson junction device 200 is formed. The capacitor 82 is formed between the electrode films 84 and 86 coupled to the Josephson junction device 200 by making the electrode films 84 and 86 face each other, for example.

Although the embodiments of the present invention have been described in detail above, the present invention is not limited to such specific embodiments, and various modifications and alternations may be made within the scope of the present invention described in the claims.

### CITATION LIST

### PATENT DOCUMENT

Patent Document 1: Japanese Laid-open Patent Publication No. 5-243626
Patent Document 2: U.S. Patent No. 4256816
Patent Document 3: Japanese National Publication of International Patent Application No. 2021-503171
Patent Document 4: U.S. Patent Application Publication No. 2021/0135085

### REFERENCE SIGNS LIST

10Substrate
12Mask layer
12aUpper layer
12bLower layer
14Superconducting film
16Insulating film
18Superconducting film
20 to 20cMask pattern
22 to 22cOpening
24 to 24cOpening
26 to 26cGap
28 to 28cOverlapping region
30 to 30cJosephson junction
34Deposition source
40, 42Arrow
50 to 50iMask pattern
52 to 52iOpening
54 to 54iOpening
56 to 56iGap
58 to 58iOverlapping region
60 to 60iJosephson junction
70, 72Arrow
80Transmon
82Capacitor
84Electrode film
86Electrode film
100, 200Josephson junction device
300Qubit

## Claims

1. A method for manufacturing a Josephson junction device (100, 200), the method comprising:
forming a mask layer (12) on a substrate (10);
forming, with the mask layer (12) as a mask, a first superconducting film (14) above the substrate (10) by first film formation from a first oblique direction relative to the substrate (10);
forming an insulating film (16) at a surface of the first superconducting film (14); and
forming, with the mask layer (12) as the mask, a second superconducting film (18) that has a region that overlaps the first superconducting film (14) via the insulating film (16) by second film formation from a second oblique direction different from the first oblique direction relative to the substrate (10),
wherein, in the forming the mask layer (12), the mask layer (12) is formed that includes: a first mask pattern (20b, 50e) that is positioned in a first region of the substrate and includes a first opening (22b, 52e) that extends along an incident direction of a film formation material in one film formation of the first film formation and the second film formation and a second opening (24b, 54e) that extends in a direction that intersects the first opening (22b, 52e); and a second mask pattern (20a, 50b) that is positioned in a second region of the substrate and includes a third opening (22a, 52b) that extends inclined relative to the first opening (22b, 52e) along the incident direction of the film formation material in the one film formation and a fourth opening (24a, 54b) that extends in a direction that intersects the third opening (22a, 52b), and the second region is positioned closer to an end of the substrate than the first region.

2. The method for manufacturing a Josephson junction device (100, 200) according to claim 1, wherein a ratio of an area of a second Josephson junction which is a region formed by the second mask pattern (20a, 50b) and in which the first superconducting film (14) and the second superconducting film (18) overlap each other via the insulating film (16) to an area of a first Josephson junction which is a region formed by the first mask pattern (20b, 50e) and in which the first superconducting film (14) and the second superconducting film (18) overlap each other via the insulating film (16) is 99% or more and 101% or less.

3. The method for manufacturing a Josephson junction device (100, 200) according to claim 1 or 2, wherein a width dimension of the first opening (22b, 52e) and a width dimension of the third opening (22a, 52b) are the same.

4. The method for manufacturing a Josephson junction device (100, 200) according to claim 1 or 2, wherein
the mask layer (12) includes an upper layer (12a) and a lower layer (12b),
the first mask pattern (20b, 50e) includes the first opening (22b, 52e) and the second opening (24b, 54e) formed in the upper layer (12a), and a first gap (26a, 56b) that is positioned below the first opening (22b, 52e) and the second opening (24b, 54e), formed in the lower layer (12b), and larger than the first opening (22b, 52e) and the second opening (24b, 54e) in plan view, and
the second mask pattern (20a, 50b) includes the third opening (22a, 52b) and the fourth opening (24a, 54b) formed in the upper layer (12a), and a second gap (26b, 56e) that is positioned below the third opening (22a, 52b) and the fourth opening (24a, 54b), formed in the lower layer (12b), and larger than the third opening (22a, 52b) and the fourth opening (24a, 54b) in plan view.

5. The method for manufacturing a Josephson junction device (100, 200) according to claim 1 or 2, wherein, in the forming the mask layer (12), the mask layer (12) is formed that has a third mask pattern (20c, 50h) that is positioned in a third region on a side opposite to the second region of the substrate relative to the first region, and includes a fifth opening (22c, 52h) that extends inclined to a side opposite to the third opening (22a, 52b) relative to the first opening (22b, 52e) along the incident direction of the film formation material in the one film formation, and a sixth opening (24c, 54h) that extends in a direction that intersects the fifth opening.

6. The method for manufacturing a Josephson junction device (100, 200) according to claim 1 or 2, wherein the first film formation and the second film formation are oblique deposition.

7. The method for manufacturing a Josephson junction device (100) according to claim 1 or 2, wherein
the second film formation from the second oblique direction is film formation from a side opposite to the first film formation from the first oblique direction relative to the substrate (10),
the first mask pattern (20b) and the second mask pattern (20a) are provided side by side in a first direction that intersects the first oblique direction and the second oblique direction,
the second opening (24b) is provided apart from the first opening (22b) in a second direction orthogonal to the first direction, and
the fourth opening (24a) is provided apart from the third opening (22a) in the second direction, and extends in the same direction as the second opening (24b).

8. The method for manufacturing a Josephson junction device (100) according to claim 7, wherein the second film formation from the second oblique direction is film formation from a direction 180° different from the first film formation from the first oblique direction relative to the substrate (10).

9. The method for manufacturing a Josephson junction device (200) according to claim 1 or 2, wherein
the second film formation from the second oblique direction is film formation from a direction that intersects the first film formation from the first oblique direction relative to the substrate (10),
the first mask pattern (50e) and the second mask pattern (50b) are provided side by side in the second oblique direction, and
the first opening (52e) and the third opening (52b) extend along the incident direction of the film formation material in the first film formation, the second opening (54e) intersects the first opening (52e) and extends along the incident direction of the film formation material in the second film formation, and the fourth opening (54b) intersects the third opening (52b) and extends in the same direction as the second opening (54e) along the incident direction of the film formation material in the second film formation.

10. The method for manufacturing a Josephson junction device (200) according to claim 9, wherein, in the forming the mask layer (12), the mask layer (12) is formed that has a fourth mask pattern (50f) that is positioned in a fourth region that has a positional relationship of 90° with the second region relative to a center of the substrate, and includes a seventh opening (52f) that extends in the same direction as the first opening (52e) along the incident direction of the film formation material in the first film formation, and an eighth opening (54f) that intersects the seventh opening and extends inclined relative to the second opening (54e) along the incident direction of the film formation material in the second film formation.

11. The method for manufacturing a Josephson junction device (200) according to claim 9, wherein, in the forming the mask layer (12), the mask layer (12) is formed that has a fifth mask pattern (50c) that is positioned in a fifth region that has a positional relationship of 45° with the second region relative to a center of the substrate, and includes a ninth opening (52c) that extends inclined relative to the first opening (52e) along the incident direction of the film formation material in the first film formation, and a tenth opening (54c) that intersects the ninth opening and extends inclined relative to the second opening (54e) along the incident direction of the film formation material in the second film formation.

12. The method for manufacturing a Josephson junction device (200) according to claim 9, wherein the second film formation from the second oblique direction is film formation from a direction 90° different from the first film formation from the first oblique direction relative to the substrate (10).

13. A method for manufacturing a qubit (300), the method comprising:
forming a Josephson junction device (100, 200) by performing the method according to claim 1; and
forming a capacitor (82) coupled in parallel to the Josephson junction device (100, 200).

## Patentansprüche

1. Verfahren zur Herstellung einer Josephson-Übergangsvorrichtung (100, 200), wobei das Verfahren Folgendes umfasst:
Bilden einer Maskenschicht (12) auf einem Substrat (10);
Bilden eines ersten supraleitenden Films (14) über dem Substrat (10) mit der Maskenschicht (12) als Maske durch eine erste Filmbildung aus einer ersten schrägen Richtung relativ zum Substrat (10);
Bilden eines isolierenden Films (16) an einer Fläche des ersten supraleitenden Films (14); und
Bilden eines zweiten supraleitenden Films (18) mit der Maskenschicht (12) als Maske, der einen Bereich aufweist, der den ersten supraleitenden Film (14) über den isolierenden Film (16) durch eine zweite Filmbildung aus einer zweiten schrägen Richtung überlappt, die sich von der ersten schrägen Richtung relativ zum Substrat (10) unterscheidet,
wobei beim Bilden der Maskenschicht (12) die Maskenschicht (12) gebildet wird, die Folgendes beinhaltet: ein erstes Maskenmuster (20b, 50e), das in einem ersten Bereich des Substrats positioniert ist und eine erste Öffnung (22b, 52e), die sich entlang einer Einfallsrichtung eines Filmbildungsmaterials bei einer Filmbildung der ersten Filmbildung und der zweiten Filmbildung erstreckt, und eine zweite Öffnung (24b, 54e) beinhaltet, die sich in einer Richtung erstreckt, die die erste Öffnung (22b, 52e) schneidet; und ein zweites Maskenmuster (20a, 50b), das in einem zweiten Bereich des Substrats positioniert ist und eine dritte Öffnung (22a, 52b), die sich relativ zur ersten Öffnung (22b, 52e) entlang der Einfallsrichtung des Filmbildungsmaterials bei der einen Filmbildung geneigt erstreckt, und eine vierte Öffnung (24a, 54b) beinhaltet, die sich in einer Richtung erstreckt, die die dritte Öffnung (22a, 52b) schneidet, und wobei der zweite Bereich näher an einem Ende des Substrats als der erste Bereich positioniert ist.

2. Verfahren zur Herstellung einer Josephson-Übergangsvorrichtung (100, 200) nach Anspruch 1, wobei ein Verhältnis einer Fläche eines zweiten Josephson-Übergangs, der ein durch das zweite Maskenmuster (20a, 50b) gebildeter Bereich ist und in dem sich der erste supraleitende Film (14) und der zweite supraleitende Film (18) über den isolierenden Film (16) überlappen, zu einer Fläche eines ersten Josephson-Übergangs, der ein durch das erste Maskenmuster (20b, 50e) gebildeter Bereich ist und in dem sich der erste supraleitende Film (14) und der zweite supraleitende Film (18) über den isolierenden Film (16) überlappen, 99 % oder mehr und 101 % oder weniger beträgt.

3. Verfahren zur Herstellung einer Josephson-Übergangsvorrichtung (100, 200) nach Anspruch 1 oder 2, wobei eine Breitenabmessung der ersten Öffnung (22b, 52e) und eine Breitenabmessung der dritten Öffnung (22a, 52b) gleich sind.

4. Verfahren zur Herstellung einer Josephson-Übergangsvorrichtung (100, 200) nach Anspruch 1 oder 2, wobei die Maskenschicht (12) eine obere Schicht (12a) und eine untere Schicht (12b) beinhaltet,
das erste Maskenmuster (20b, 50e) die erste Öffnung (22b, 52e) und die zweite Öffnung (24b, 54e), die in der oberen Schicht (12a) gebildet sind, und einen ersten Spalt (26a, 56b) beinhaltet, der unterhalb der ersten Öffnung (22b, 52e) und der zweiten Öffnung (24b, 54e) positioniert ist, in der unteren Schicht (12b) gebildet ist und in Draufsicht größer als die erste Öffnung (22b, 52e) und die zweite Öffnung (24b, 54e) ist, und
das zweite Maskenmuster (20a, 50b) die dritte Öffnung (22a, 52b) und die vierte Öffnung (24a, 54b), die in der oberen Schicht (12a) gebildet sind, und einen zweiten Spalt (26b, 56e) beinhaltet, der unterhalb der dritten Öffnung (22a, 52b) und der vierten Öffnung (24a, 54b) positioniert ist, in der unteren Schicht (12b) gebildet ist und in Draufsicht größer als die dritte Öffnung (22a, 52b) und die vierte Öffnung (24a, 54b) ist.

5. Verfahren zur Herstellung einer Josephson-Übergangsvorrichtung (100, 200) nach Anspruch 1 oder 2, wobei beim Bilden der Maskenschicht (12) die Maskenschicht (12) gebildet wird, die ein drittes Maskenmuster (20c, 50h) aufweist, das in einem dritten Bereich auf einer dem zweiten Bereich des Substrats gegenüberliegenden Seite relativ zum ersten Bereich positioniert ist, und eine fünfte Öffnung (22c, 52h), die sich geneigt zu einer Seite gegenüber der dritten Öffnung (22a, 52b) relativ zur ersten Öffnung (22b, 52e) entlang der Einfallsrichtung des Filmbildungsmaterials bei der einen Filmbildung erstreckt, und eine sechste Öffnung (24c, 54h) beinhaltet, die sich in einer Richtung erstreckt, die die fünfte Öffnung schneidet.

6. Verfahren zur Herstellung einer Josephson-Übergangsvorrichtung (100, 200) nach Anspruch 1 oder 2, wobei die erste Filmbildung und die zweite Filmbildung durch Schrägabscheidung erfolgen.

7. Verfahren zur Herstellung einer Josephson-Übergangsvorrichtung (100) nach Anspruch 1 oder 2, wobei
die zweite Filmbildung aus der zweiten schrägen Richtung eine Filmbildung von einer Seite ist, die der ersten Filmbildung aus der ersten schrägen Richtung relativ zum Substrat (10) gegenüberliegt,
das erste Maskenmuster (20b) und das zweite Maskenmuster (20a) nebeneinander in einer ersten Richtung bereitgestellt sind, die die erste schräge Richtung und die zweite schräge Richtung schneidet,
die zweite Öffnung (24b) von der ersten Öffnung (22b) in einer zweiten Richtung orthogonal zur ersten Richtung getrennt bereitgestellt ist, und
die vierte Öffnung (24a) von der dritten Öffnung (22a) in der zweiten Richtung getrennt bereitgestellt ist und sich in die gleiche Richtung wie die zweite Öffnung (24b) erstreckt.

8. Verfahren zur Herstellung einer Josephson-Übergangsvorrichtung (100) nach Anspruch 7, wobei die zweite Filmbildung aus der zweiten schrägen Richtung eine Filmbildung aus einer Richtung ist, die sich um 180° von der ersten Filmbildung aus der ersten schrägen Richtung relativ zum Substrat (10) unterscheidet.

9. Verfahren zur Herstellung einer Josephson-Übergangsvorrichtung (200) nach Anspruch 1 oder 2, wobei
die zweite Filmbildung aus der zweiten schrägen Richtung eine Filmbildung aus einer Richtung ist, die die erste Filmbildung aus der ersten schrägen Richtung relativ zum Substrat (10) schneidet,
das erste Maskenmuster (50e) und das zweite Maskenmuster (50b) nebeneinander in der zweiten schrägen Richtung bereitgestellt sind, und
die erste Öffnung (52e) und die dritte Öffnung (52b) sich entlang der Einfallsrichtung des Filmbildungsmaterials bei der ersten Filmbildung erstrecken, die zweite Öffnung (54e) die erste Öffnung (52e) schneidet und sich entlang der Einfallsrichtung des Filmbildungsmaterials bei der zweiten Filmbildung erstreckt, und die vierte Öffnung (54b) die dritte Öffnung (52b) schneidet und sich in der gleichen Richtung wie die zweite Öffnung (54e) entlang der Einfallsrichtung des Filmbildungsmaterials bei der zweiten Filmbildung erstreckt.

10. Verfahren zur Herstellung einer Josephson-Übergangsvorrichtung (200) nach Anspruch 9, wobei beim Bilden der Maskenschicht (12) die Maskenschicht (12) gebildet wird, die ein viertes Maskenmuster (50f) aufweist, das in einem vierten Bereich positioniert ist, der eine Positionsbeziehung von 90° zum zweiten Bereich relativ zu einer Mitte des Substrats aufweist, und eine siebte Öffnung (52f), die sich in der gleichen Richtung wie die erste Öffnung (52e) entlang der Einfallsrichtung des Filmbildungsmaterials bei der ersten Filmbildung erstreckt, und eine achte Öffnung (54f) beinhaltet, die die siebte Öffnung schneidet und sich geneigt relativ zur zweiten Öffnung (54e) entlang der Einfallsrichtung des Filmbildungsmaterials bei der zweiten Filmbildung erstreckt.

11. Verfahren zur Herstellung einer Josephson-Übergangsvorrichtung (200) nach Anspruch 9, wobei beim Bilden der Maskenschicht (12) die Maskenschicht (12) gebildet wird, die ein fünftes Maskenmuster (50c) aufweist, das in einem fünften Bereich positioniert ist, der eine Positionsbeziehung von 45° zum zweiten Bereich relativ zu einer Mitte des Substrats aufweist, und eine neunte Öffnung (52c), die sich geneigt relativ zur ersten Öffnung (52e) entlang der Einfallsrichtung des Filmbildungsmaterials bei der ersten Filmbildung erstreckt, und eine zehnte Öffnung (54c) beinhaltet, die die neunte Öffnung schneidet und sich geneigt relativ zur zweiten Öffnung (54e) entlang der Einfallsrichtung des Filmbildungsmaterials bei der zweiten Filmbildung erstreckt.

12. Verfahren zur Herstellung einer Josephson-Übergangsvorrichtung (200) nach Anspruch 9, wobei die zweite Filmbildung aus der zweiten schrägen Richtung eine Filmbildung aus einer Richtung ist, die sich um 90° von der ersten Filmbildung aus der ersten schrägen Richtung relativ zum Substrat (10) unterscheidet.

13. Verfahren zur Herstellung eines Qubits (300), wobei das Verfahren Folgendes umfasst:
Bilden einer Josephson-Übergangsvorrichtung (100, 200) durch Durchführen des Verfahrens nach Anspruch 1; und
Bilden eines Kondensators (82), der parallel zur Josephson-Übergangsvorrichtung (100, 200) geschaltet ist.

## Revendications

1. Procédé de fabrication d'un dispositif de jonction Josephson (100, 200), le procédé comprenant :
la formation d'une couche de masque (12) sur un substrat (10) ; la formation, avec la couche de masque (12) comme masque, d'un premier film supraconducteur (14) au-dessus du substrat (10) par première formation de film à partir d'une première direction oblique par rapport au substrat (10) ;
la formation d'un film isolant (16) au niveau d'une surface du premier film supraconducteur (14) ; et
la formation, avec la couche de masque (12) comme masque, d'un second film supraconducteur (18) qui présente une région qui chevauche le premier film supraconducteur (14) par l'intermédiaire du film isolant (16) par seconde formation de film à partir d'une seconde direction oblique différente de la première direction oblique par rapport au substrat (10),
dans lequel, dans la formation de la couche de masque (12), la couche de masque (12) est formée, qui comporte : un premier motif de masque (20b, 50e) qui est positionné dans une première région du substrat et comporte une première ouverture (22b, 52e) qui s'étend le long d'une direction d'incidence d'un matériau de formation de film dans une formation de film de la première formation de film et la seconde formation de film et une deuxième ouverture (24b, 54e) qui s'étend dans une direction qui croise la première ouverture (22b, 52e) ; et un deuxième motif de masque (20a, 50b) qui est positionné dans une deuxième région du substrat et comporte une troisième ouverture (22a, 52b) qui s'étend de manière inclinée par rapport à la première ouverture (22b, 52e) le long de la direction d'incidence du matériau de formation de film dans la formation de film et une quatrième ouverture (24a, 54b) qui s'étend dans une direction qui croise la troisième ouverture (22a, 52b), et la deuxième région est positionnée plus proche d'une extrémité du substrat que la première région.

2. Procédé de fabrication d'un dispositif de jonction Josephson (100, 200) selon la revendication 1, dans lequel un rapport entre une zone d'une seconde jonction Josephson qui est une région formée par le deuxième motif de masque (20a, 50b) et dans laquelle le premier film supraconducteur (14) et le second film supraconducteur (18) se chevauchent par l'intermédiaire du film isolant (16) et une zone d'une première jonction Josephson qui est une région formée par le premier motif de masque (20b, 50e) et dans laquelle le premier film supraconducteur (14) et le second film supraconducteur (18) se chevauchent par l'intermédiaire du film isolant (16) est compris entre 99 % inclus et 101 % inclus.

3. Procédé de fabrication d'un dispositif de jonction Josephson (100, 200) selon la revendication 1 ou 2, dans lequel une dimension de largeur de la première ouverture (22b, 52e) et une dimension de largeur de la troisième ouverture (22a, 52b) sont identiques.

4. Procédé de fabrication d'un dispositif de jonction Josephson (100, 200) selon la revendication 1 ou 2, dans lequel la couche de masque (12) comporte une couche supérieure (12a) et une couche inférieure (12b),
le premier motif de masque (20b, 50e) comporte la première ouverture (22b, 52e) et la deuxième ouverture (24b, 54e) formées dans la couche supérieure (12a), et un premier espace (26a, 56b) qui est positionné au-dessous de la première ouverture (22b, 52e) et de la deuxième ouverture (24b, 54e), formé dans la couche inférieure (12b), et plus grand que la première ouverture (22b, 52e) et la deuxième ouverture (24b, 54e) dans une vue en plan, et
le deuxième motif de masque (20a, 50b) comporte la troisième ouverture (22a, 52b) et la quatrième ouverture (24a, 54b) formées dans la couche supérieure (12a), et un second espace (26b, 56e) qui est positionné au-dessous de la troisième ouverture (22a, 52b) et de la quatrième ouverture (24a, 54b), formé dans la couche inférieure (12b), et plus grand que la troisième ouverture (22a, 52b) et la quatrième ouverture (24a, 54b) dans une vue en plan.

5. Procédé de fabrication d'un dispositif de jonction Josephson (100, 200) selon la revendication 1 ou 2, dans lequel, dans la formation de la couche de masque (12), la couche de masque (12) est formée, qui présente un troisième motif de masque (20c, 50h) qui est positionné dans une troisième région sur un côté opposé à la deuxième région du substrat par rapport à la première région, et comporte une cinquième ouverture (22c, 52h) qui s'étend de manière inclinée vers un côté opposé à la troisième ouverture (22a, 52b) par rapport à la première ouverture (22b, 52e) le long de la direction d'incidence du matériau de formation de film dans la formation de film, et une sixième ouverture (24c, 54h) qui s'étend dans une direction qui croise la cinquième ouverture.

6. Procédé de fabrication d'un dispositif de jonction Josephson (100, 200) selon la revendication 1 ou 2, dans lequel la première formation de film et la seconde formation de film sont des dépôts obliques.

7. Procédé de fabrication d'un dispositif de jonction Josephson (100) selon la revendication 1 ou 2, dans lequel
la seconde formation de film à partir de la seconde direction oblique est une formation de film à partir d'un côté opposé à la première formation de film à partir de la première direction oblique par rapport au substrat (10),
le premier motif de masque (20b) et le deuxième motif de masque (20a) sont prévus côte à côte dans une première direction qui croise la première direction oblique et la seconde direction oblique,
la deuxième ouverture (24b) est prévue à l'écart de la première ouverture (22b) dans une seconde direction orthogonale à la première direction, et
la quatrième ouverture (24a) est prévue à l'écart de la troisième ouverture (22a) dans la seconde direction, et s'étend dans la même direction que la deuxième ouverture (24b).

8. Procédé de fabrication d'un dispositif de jonction Josephson (100) selon la revendication 7, dans lequel la seconde formation de film à partir de la seconde direction oblique est une formation de film à partir d'une direction de 180 ° différente de la première formation de film à partir de la première direction oblique par rapport au substrat (10).

9. Procédé de fabrication d'un dispositif de jonction Josephson (200) selon la revendication 1 ou 2, dans lequel
la seconde formation de film à partir de la seconde direction oblique est une formation de film à partir d'une direction qui croise la première formation de film à partir de la première direction oblique par rapport au substrat (10),
le premier motif de masque (50e) et le deuxième motif de masque (50b) sont prévus côte à côte dans la seconde direction oblique, et
la première ouverture (52e) et la troisième ouverture (52b) s'étendent le long de la direction d'incidence du matériau de formation de film dans la première formation de film, la deuxième ouverture (54e) croise la première ouverture (52e) et s'étend le long de la direction d'incidence du matériau de formation de film dans la seconde formation de film, et la quatrième ouverture (54b) croise la troisième ouverture (52b) et s'étend dans la même direction que la deuxième ouverture (54e) le long de la direction d'incidence du matériau de formation de film dans la seconde formation de film.

10. Procédé de fabrication d'un dispositif de jonction Josephson (200) selon la revendication 9, dans lequel, dans la formation de la couche de masque (12), la couche de masque (12) est formée, qui présente un quatrième motif de masque (50f) qui est positionné dans une quatrième région qui présente une relation de position de 90 °avec la deuxième région par rapport à un centre du substrat, et comporte une septième ouverture (52f) qui s'étend dans la même direction que la première ouverture (52e) le long de la direction d'incidence du matériau de formation de film dans la première formation de film, et une huitième ouverture (54f) qui croise la septième ouverture et s'étend de manière inclinée par rapport à la deuxième ouverture (54e) le long de la direction d'incidence du matériau de formation de film dans la seconde formation de film.

11. Procédé de fabrication d'un dispositif de jonction Josephson (200) selon la revendication 9, dans lequel, dans la formation de la couche de masque (12), la couche de masque (12) est formée, qui présente un cinquième motif de masque (50c) qui est positionné dans une cinquième région qui présente une relation de position de 45 ° avec la deuxième région par rapport à un centre du substrat, et comporte une neuvième ouverture (52c) qui s'étend de manière inclinée par rapport à la première ouverture (52e) le long de la direction d'incidence du matériau de formation de film dans la première formation de film, et une dixième ouverture (54c) qui croise la neuvième ouverture et s'étend de manière inclinée par rapport à la deuxième ouverture (54e) le long de la direction d'incidence du matériau de formation de film dans la seconde formation de film.

12. Procédé de fabrication d'un dispositif de jonction Josephson (200) selon la revendication 9, dans lequel la seconde formation de film à partir de la seconde direction oblique est une formation de film à partir d'une direction de 90 ° différente de la première formation de film à partir de la première direction oblique par rapport au substrat (10).

13. Procédé de fabrication d'un qubit (300), le procédé comprenant :
la formation d'un dispositif de jonction Josephson (100, 200) en mettant en œuvre le procédé selon la revendication 1 ; et
la formation d'un condensateur (82) couplé en parallèle au dispositif de jonction Josephson (100, 200).
